# EUROPEAN PATENT APPLICATION

(11) **EP 4 079 933 A1**
(43) Date of publication of application: **26.10.2022**
(21) Application number: 20901681.5
(22) Date of filing: 09.06.2020
(51) Int. Cl.: C23C 16/513, C23C 16/455, C23C 16/458, H01L 21/205, H05H 1/24

(54) **COATING APPARATUS AND COATING METHOD**

(30) Priority: 18.12.2019 CN 201911310683
(71) Applicant: Jiangsu Favored Nanotechnology Co., Ltd., Yuqi Industry Park, Huishan District Wuxi Jiangsu 214000 (CN)
(72) Inventor: ZONG, Jian, Wuxi, Jiangsu 214112 (CN)
(74) Representative: Mewburn Ellis LLP
(86) International application number: PCT/CN2020/095077
(87) International publication number: WO 2021/120542

(57) **Abstract**

Provided is a coating device and a coating method. The coating device includes a reaction chamber, a support frame, a monomer release source and a plasma excitation source. The support frame has a support region for supporting a substrate. The monomer release source has a release inlet for introducing a film layer forming material such that same enters the reaction chamber. The plasma excitation source is arranged to activate the film layer forming material, and the support region of the support frame is positioned between the monomer release source and the plasma excitation source, such that a film layer is uniformly formed on a surface of the substrate, and the deposition speed is accelerated.

## Description

### TECHNICAL FIELD

The present disclosure relates to depositional coating, and particularly, to a coating apparatus and a coating method, for applying and forming a coating on a substrate, which is adapted to be disposed between a release source of a coating forming material and a plasma excitation source to prevent excessive decomposition of the coating forming material during a coating forming process.

### BACKGROUND

Coating apparatus is disposed to form a polymer coating or thin coating on a surface of a substrate, which is made of materials including, but not limited to, metals, glasses, ceramics, polymers, fibers, powders, and semiconductors, thereby improving various properties of the substrate, such as hydrophobicity, hydrophilicity, oleophobicity, rust resistance, mildew resistance, moisture resistance, electrical and thermal conductivity, biomedical, optical, and friction properties.

A typical coating apparatus utilizes the plasma vapor deposition method PECVD (Plasma Enhanced Chemical Vapor Deposition), and is generally manufactured for introducing a gaseous coating forming material into a vacuum chamber in which the substrate(s) is placed, so that a polymer coating is formed on the surface of the substrate(s). More specifically, the gaseous coating forming material, which may include, but is not limited to, organic materials, organic silicon materials, inorganic materials, and combinations of the above, is a monomer gas or a monomer vapor, which is released thereto electrical energy to produce a variety of reactive precursor species by being activated to be in a plasma state on the substrate. Then, a reaction between the reactive precursor species and the monomer, or between the reactive precursor species themselves occurs, and a polymer thin coating is subsequently deposited and formed on the surface of the substrate.

The monomer should be excited to produce the reactive precursor species, but overexposure of the monomer to a plasma excitation medium may lead to excessive decomposition of the monomer, so that deposition speed and uniformity of the polymer coating may be adversely affected.

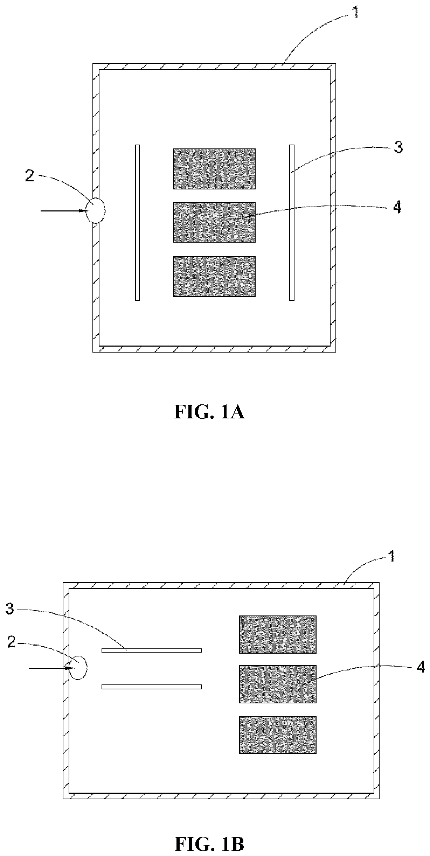

As shown in FIG. 1A, an existing coating apparatus includes a chamber body 1, a release source 2 of a coating forming material for introducing the coating forming material into the chamber body 1, and a plasma excitation source 3 for applying electrical energy to the coating forming material to excite the coating forming material. As shown, one or more substrates 4 are arranged between opposite electrodes of the plasma excitation source 3. The coating forming material is dispersed into a space between the opposite electrodes of the plasma excitation source 3 to undergo an excitation process for generating a reactive precursor species. Since the coating forming material is excited under the effect of the plasma excitation source 3 and then deposited on the substrates 4 placed in the plasma excitation source 3, the coating forming material may be excessively decomposed. In addition, exposure of the substrates 4 between the electrodes of the plasma excitation source 3 may also cause damage to the substrates 4.

As shown in FIG. 1B, another existing coating apparatus includes a chamber body 1, a release source 2 of a coating forming material, and a plasma excitation source 3 placed between the release source 2 of the coating forming material and substrates 4 to be coated. During the coating process, the coating forming material is required to pass through a space between opposite electrodes of the plasma excitation source 3 to perform an excitation process for generating a reactive precursor species before reaching the substrates 4.

US Patent No. US7,968,154B2 entitled "Atomisation Of A Precursor Into An Excitation Medium For Coating A Remote Substrate" and US Patent No. US8,029,872B2 entitled "Application Of A Coating Forming Material Onto At Least One Substrate" disclose such a coating apparatus including a vaporized monomer source and a plasma excitation medium. The substrate and the vaporized monomer source are respectively located on two opposite sides of the plasma excitation medium, and the vaporized monomer source passes through the plasma excitation medium and is then deposited on the substrate surface on the opposite side of the plasma excitation medium to form a polymer coating. It can thus be seen that, the vaporized monomer may be deposited on the surface of the substrate merely after passing through the plasma excitation medium. The plasma excitation medium may decompose a relatively large portion of the vaporized monomer in a relatively long time, so that excessive decomposition of the vaporized monomer may occur, and thus the formed coating will hardly maintain the chemical properties of the vaporized coating forming material.

U.S. Patent Application No. US16/095179 entitled "Multi-Source Low-Power Low-Temperature Plasma Polymerization Coating Device And Method" discloses a coating device, which generates a high-frequency discharge by combining a plurality of small-area and low-power light sources instead of by a single large-area and high-power high-frequency discharge source. However, this method still excessively disrupts chemical monomer structure of the monomer to some extent, and results in an unsatisfactory quality of the formed polymer coating, and the device is relatively complex in structure and difficult to assemble.

### SUMMARY

One major advantage of the present disclosure is to provide a coating apparatus and a coating method, wherein during a plasma polymerization coating method, a substrate is adapted to have a coating formed on a surface thereof without unduly damaging the coating forming material.

Another advantage of the present disclosure is to provide a coating apparatus and a coating method, wherein the substrate to be coated is adapted to be placed between a monomer release source for introducing a coating forming material into a chamber body and a plasma excitation source for exciting the coating forming material, so that the coating forming material as a gaseous monomer or monomer vapor is not required to pass through the plasma excitation source before reaching the substrate, thus reducing the excessive decomposition of the coating forming material.

Another advantage of the present disclosure is to provide a coating apparatus and a coating method, wherein the substrate to be coated is adapted to be placed at a position having a distance smaller to the monomer release source than to the plasma excitation source in such a way that, at least a portion of the coating forming material reaches the area where the substrate is positioned before reaching the plasma excitation source, so that not all of the coating forming material is required to pass through the plasma excitation source before reaching the substrate.

Another advantage of the present disclosure is to provide a coating apparatus and a coating method, wherein the monomer release source, a support frame for supporting the substrate, and the plasma excitation source are configured to maintain a desired level of reaction between reactive precursor species, which results from a proportion of the monomer reaching the plasma excitation source while another portion of the monomer having not yet been decomposed into reactive precursor species, thus enhancing the quality of the polymer coating formed on the surface of the substrate.

Another advantage of the present disclosure is to provide a coating apparatus and a coating method, wherein according to some embodiments, the substrate to be coated may be supported on the support frame movable between the monomer release source and the plasma excitation source to adjust the distance between the substrate and the plasma excitation source, so as to control and adjust the composition of the formed polymer material deposited on the surface of the substrate.

Another advantage of the present disclosure is to provide a coating apparatus and a coating method, wherein according to some embodiments, the plasma excitation source is provided at a substantially central position of a reaction chamber of the chamber body, while a plurality of the substrates may be arranged around the plasma excitation source, wherein the coating forming material, which may be released from the monomer release source at a position adjacent to an inner wall of the chamber body, is radially dispersed into the reaction chamber and has to pass through the area where the substrate is placed before reaching the plasma excitation source.

Another advantage of the present disclosure is to provide a coating apparatus and a coating method, wherein according to some embodiments, the support frame for supporting the substrate may be implemented to include a rotary frame rotating relative to the plasma excitation source in the reaction chamber, to change the relative position between the substrate and the plasma excitation source, and also play a role of stirring the vaporous coating forming material dispersed into the reaction chamber, so as to improve the uniformity of the polymer coating formed on the surface of the substrate.

Another advantage of the present disclosure is to provide a coating apparatus and a coating method, wherein according to some embodiments, the relative movement between the substrate and the monomer release source of the coating forming material is controllable, thereby adjusting the amount of the coating forming material reaching the substrate, without influence of excitation by the plasma excitation source, so that the reactive precursor species and the monomer may be fully reacted, which enables a high-quality polymer coating to be deposited on the surface of the substrate.

Another advantage of the present disclosure is to provide a coating apparatus and a coating method, wherein according to some embodiments, the relative movement between the substrate and the plasma excitation source is controllable, to control the amount of the reactive precursor species reaching the surface, to allow sufficient reaction of the reactive precursor species and the monomer before the polymer coating is formed on the surface of the substrate.

Another advantage of the present disclosure is to provide a coating apparatus and a coating method, wherein according to some embodiments, the substrate is adapted to be supported on a support frame rotatable about a central axis thereof and also along a rotary frame, to adjust the relative position between the substrate and the plasma excitation source, to adjust the amounts of the reactive precursor species and the monomer reaching the substrate, so as to form a polymer coating on the surface of the substrate.

Another advantage of the present disclosure is to provide a coating apparatus and a coating method, wherein the substrate to be coated is adapted to be arranged outside the plasma excitation source, thereby avoiding damage to the substrate by the plasma excitation source during the coating process.

Another advantage of the present disclosure is to provide a coating apparatus and a coating method, wherein the coating is uniformly formed on the surface of the substrate, and the deposition speed is increased.

Another advantage of the present disclosure is to provide a coating apparatus and a coating method, wherein the utilization amount of the coating forming material for forming the polymer coating is increased, thereby avoiding waste and reducing costs.

Another advantage of the present disclosure is to provide a coating apparatus and a coating method, wherein graft growth and crosslinking in the molecular structure of the polymer coating are enhanced, and the integrity of the molecular structure of the polymer coating is achieved, thereby ensuring good performance of the polymer coating.

Another advantage of the present disclosure is to provide a coating apparatus and a coating method, wherein the device is simple in structure and easy to operate and maintain.

Other advantages and features of the present disclosure will be fully embodied from the following detailed description and may be realized by combinations of the means and instrumentalities particularly pointed out in the appended claims.

According to one aspect of the present disclosure, a coating apparatus for forming a coating on a surface of a substrate of the present disclosure capable of achieving the aforementioned and other objects and advantages includes a chamber body, a monomer release source and a plasma excitation source. The chamber body has a reaction chamber, wherein the chamber body has a substrate positioning area for positioning the substrate. The monomer release source has a release inlet for introducing a coating forming material into the reaction chamber of the chamber body. The plasma excitation source is provided in the reaction chamber of the chamber body for exciting the coating forming material, wherein the substrate positioning area is located between the monomer release source and the plasma excitation source in such a manner that the substrate is adapted to be arranged between the monomer release source and the plasma excitation source.

According to another aspect of the present disclosure, the present disclosure provides a coating apparatus for forming a coating on a surface of a substrate, wherein the coating apparatus includes a chamber body having a reaction chamber, a support frame, a monomer release source, and a plasma excitation source. The support frame has a support area for supporting the substrate in the reaction chamber of the chamber body. The monomer release source has a release inlet for introducing a coating forming material into the reaction chamber of the chamber body. The plasma excitation source is provided in the reaction chamber of the chamber body for exciting the coating forming material, wherein the support area of the support frame is located between the monomer release source and the plasma excitation source, such that the substrate is adapted to be arranged between the monomer release source and the plasma excitation source.

According to another aspect of the present disclosure, the present disclosure provides a coating method for forming a coating on a surface of a substrate, wherein the coating method includes the following steps:
(a) arranging the substrate in a reaction chamber of a chamber body at a position between a monomer release source and a plasma excitation source; and
(b) introducing a coating forming material into the reaction chamber through the monomer release source, to form a polymer coating on the surface of the substrate under the effect of the plasma excitation source.

Further objects and advantages of the present disclosure will be fully embodied by an understanding of the ensuing description and drawings.

These and other objects, features and advantages of the present disclosure are fully embodied by the following detailed description, drawings and claims.

### BRIEF DESCRIPTION OF THE DRAWINGS

FIG. 1A is a schematic view of an existing coating apparatus;
FIG. 1B is a schematic view of another existing coating apparatus;
FIG. 2A is a schematic view of the principle of a coating apparatus according to a first preferred embodiment of the present disclosure;
FIG. 2B is a schematic view of the principle of the coating apparatus according to the above first preferred embodiment of the present disclosure, illustrating that the coating apparatus is placed with a substrate to implement a coating method;
FIG. 2C is a schematic view of the principle of the coating apparatus according to a feasible mode of the above first preferred embodiment of the present disclosure;
FIG. 2D is a schematic view of the principle of the coating apparatus according to another feasible mode of the above first preferred embodiment of the present disclosure;
FIG. 3A is a schematic view of the principle of a coating apparatus according to a second preferred embodiment of the present disclosure;
FIG. 3B and FIG. 3C are schematic views of the principle of the coating apparatus according to the above second preferred embodiment of the present disclosure, illustrating that a support frame carries the substrate and moves between a monomer release source and a plasma excitation source;
FIG. 4A is a schematic view of the principle of the coating apparatus according to a feasible mode of the above second preferred embodiment of the present disclosure;
FIG. 4B is a schematic view of the principle of the coating apparatus according to another feasible mode of the above second preferred embodiment of the present disclosure;
FIG. 5A and FIG. 5B are schematic views of the principle of the coating apparatus according to a feasible mode of the above second preferred embodiment of the present disclosure, illustrating that a support frame is configured with a plasma excitation source and carries the substrate to move between a monomer release source and the plasma excitation source;
FIG. 6A and FIG. 6B are schematic views of the principle of the coating apparatus according to a feasible mode of the above second preferred embodiment of the present disclosure, illustrating that a support frame carries the substrate to moves near or far to a monomer release source;
FIG. 7 is a schematic view of the principle of a coating apparatus according to a third preferred embodiment of the present disclosure;
FIG. 8 is a schematic view of the principle of the coating apparatus according to a feasible mode of the above third preferred embodiment of the present disclosure;
FIG. 9 is a schematic view of the principle of the coating apparatus according to another feasible mode of the above third preferred embodiment of the present disclosure;
FIG. 10 is a schematic module diagram of a coating apparatus according to a fourth preferred embodiment of the present disclosure;
FIG. 11 is a structural block diagram of the coating apparatus according to the above fourth preferred embodiment of the present disclosure;
FIG. 12 is a schematic structural view of a coating apparatus according to a first variation embodiment of the present disclosure;
FIG. 13 is a schematic structural view of a coating apparatus according to a second variation embodiment of the present disclosure;
FIG. 14 is a schematic structural view of a variant implementation of the coating apparatus according to the second variation embodiment of the present disclosure; and
FIG. 15 is a schematic module diagram of a revolution frame of a variant implementation of the coating apparatus according to the second variation embodiment of the present disclosure.

### DETAILED DESCRIPTION

The following description serves to disclose the disclosure to enable those skilled in the art to practice the present disclosure. The embodiments in the following description are only for examplification. Those skilled in the art may think of other obvious variations. The basic principles of the present disclosure as defined in the following description may be applied to other embodiments, variations, modifications, equivalents, and other technical solutions without departing from the spirit and scope of the present disclosure.

Those skilled in the art will appreciate that, in the disclosure of the present disclosure, the terms "longitudinal", "transverse", "upper", "lower", "front", "rear", "left", "right", "vertical", "horizontal", "top", "bottom", "inner", "outer" and the like indicate azimuth or positional relationships based on the azimuth or positional relationships shown in the drawings. It is only intended to facilitate the description and simplify the description, and not to indicate or imply that the apparatus or element referred to must have a particular orientation, be constructed and operated in a particular orientation, so the above-mentioned terms are not to be construed to limit the present disclosure.

It will be appreciated that the term "a", "an", or "one" is to be understood as "at least one" or "one or more", i.e., in one embodiment, the number of one element may be one and in another embodiment the number of one element may be multiple, and that the term "a", "an", or "one" is not to be construed to limit the number.

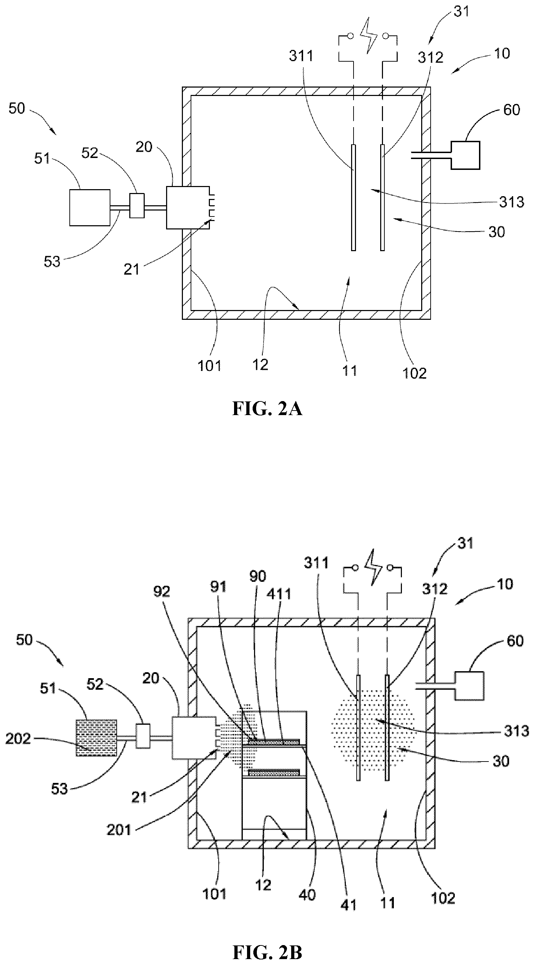

Referring to FIGS. 2A and 2B, a coating apparatus, arranged to implement a novel plasma polymerization coating method for forming a polymer coating 92 on a surface 91 of a substrate 90, is explained according to a first preferred embodiment of the present disclosure. More specifically, the coating apparatus includes a chamber body 10 defining a reaction chamber 11, a monomer release source 20 communicated with the reaction chamber 11 and used to introduce a coating forming material 201 as a gaseous monomer or monomer vapor into the reaction chamber 11 of the chamber body 10, and a plasma excitation source 30 operable to generate an induced electric field inside the reaction chamber 11 to form plasma in such a manner that the plasma excitation source 30 applies electrical energy to the coating forming material 201 to excite the coating forming material 201, so as to decompose the coating forming material 201 to form a reactive precursor species, so that the coating forming material 201 is activated into a plasma state, thereby inducing a reaction between the reactive precursor species and the monomer, as well as a reaction between the reactive precursor species in the reaction chamber 11 of the chamber body 10, so that the polymer coating 92 is then deposited and formed on the surface 91 of the substrate 90.

According to this preferred embodiment of the present disclosure, as shown in FIG. 2B, the plasma excitation source 30 is arranged in the reaction chamber 11 of the chamber body 10 at a position away from the monomer release source 20. The chamber body 10 has a substrate positioning area 12 arranged between the monomer release source 20 and the plasma excitation source 30, so that at least one of the substrates 90 is adapted to be arranged in the reaction chamber 11 between the monomer release source 20 and the plasma excitation source 30, so as to form the polymer coating 92 on the surface 91 of the substrate 90 in the plasma polymerization coating method of the present disclosure.

Correspondingly, in the plasma polymerization coating method of the substrate 90, one or more of the substrates 90 may be provided at the substrate positioning area 12 of the chamber body 10 in such a manner that the monomer release sources 20 is arranged on a first side of the substrate positioning area 12 of the chamber body 10 and the plasma excitation source 30 is located on an opposite second side of the substrate 90, so that when the coating forming material 201 is released into the reaction chamber 11 of the chamber body 10, the coating forming material 201 does not have to pass through the plasma excitation source 30 before reaching the substrate 90, so as to avoid excessive decomposition of the coating forming material 201.

Specifically, when the monomer release source 20 is operated to release the coating forming material 201, the coating forming material 201 is dispersed into the reaction chamber 11 of the chamber body 10 and firstly reaches the substrate positioning area 12 of the chamber body 10, only a portion of the coating forming material 201 is excited by the plasma excitation source 30 to decompose, polymerize, and deposit on the surface 91 of the substrate, to form the polymer coating 92.

In the plasma polymerization coating method of the present disclosure, since the substrate 90 is adapted to be placed in a flow path of the coating forming material 201 flowing from the monomer release source 20 to the plasma excitation source 30, and the distance between the substrate 90 and the monomer release source 20 is smaller than that between the substrate 90 and the plasma excitation source 30, not all the coating forming material 201 is excited by the plasma excitation source 30, thereby avoiding excessive decomposition of the coating forming material 201.

The substrate 90 may be placed directly at the substrate positioning area 12 of the chamber body 10. Alternatively, as shown in FIG. 2B, a plurality of the substrates 90 may be placed on the support frame 40, and then, the support frame 40 loaded with the plurality of the substrates 90 is placed at the substrate positioning area 12 of the chamber body 10 and accommodated in the reaction chamber 11 of the chamber body 10. Alternatively, the support frame 40 may be placed at the substrate positioning area 12 of the chamber body 10 and accommodated in the reaction chamber 11 of the chamber body 10, and then a plurality of the substrates 90 are placed on the support frame 40. In another feasible mode, the support frame 40 is configured to the chamber body 10 and placed in the reaction chamber 11, and a plurality of the substrates 90 are placed on the support frame 40 in the coating process.

The support frame 40 includes a carrier frame 41 which may include a plurality of support platforms for supporting multiple layers of the substrates 90. The carrier frame 41 has a support area 411 for placing and supporting the substrate 90, and the support area 411 is arranged between the monomer release source 20 and the plasma excitation source 30. In a feasible mode, the entire support frame 40 may not be arranged between the monomer release source 20 and the plasma excitation source 30, but the support area 411 of the support frame 40 for supporting the substrate 90 is arranged between the monomer release source 20 and the plasma excitation source 30, and the substrate 90 placed on the support area 411 of the support frame may be placed between the monomer release source 20 and the plasma excitation source 30.

Those skilled in the art should understand that, the substrate positioning area 12 of the chamber body 10 is an area for directly supporting one or more of the substrates 90, or an area for supporting and accommodating the support frame 40 adapted for loading one or more of the substrates 90.

The chamber body 10 of the present disclosure is a housing that defines the reaction chamber 11. The cross section of the reaction chamber 11 of the chamber body 10 may be, but is not limited to, a circular shape, an oval shape, a polygonal shape, such as, a rectangular shape, a pentagonal shape, a hexagonal shape, a heptagonal shape, an octagonal shape, a nonagonal shape, and a decagonal shape. As an example of this preferred embodiment, the chamber body 10 is configured to have a rectangular reaction chamber 11. The monomer release source 20 is arranged on a first side of the rectangular reaction chamber 11, and the plasma excitation source 30 may be arranged on an opposite second side of the rectangular reaction chamber 11. As shown in the figure, while the plasma excitation source 30 is away from the monomer release source 20, the monomer release source 20 may be arranged adjacent to the first side wall 101 of the chamber body 10, and the plasma excitation source 30 is arranged at the second side wall 102 of the chamber body 10, with the second side wall 102 being opposite to the first side wall 101 of the chamber body 10.

The monomer release source 20 has at least one release inlet 21 for introducing the coating forming material 201 into the reaction chamber 11 of the chamber body 10. The release inlet 21 is formed on the wall of the chamber body 10 and penetrates the wall layer of the chamber body 10. Alternatively, the release inlet 21 may be formed in a supply nozzle embedded in the chamber body 10. Alternatively, the release inlet 21 is formed in a supply nozzle, a feed head located at the distal end of the feed pipe, extending to the reaction chamber 11 of the chamber body 10.

According to this preferred embodiment of the present disclosure, the coating apparatus further includes a monomer supply unit 50 for supplying the coating forming material 201 to the monomer release source 20. More specifically, the monomer supply unit 50 of this preferred embodiment includes a material storage device 51 for storing the raw material 202 of the coating forming material 201, a vaporizer 52 for vaporizing the raw material 202, and a transmitting pipe system 53 used to transmit the raw material 202 from the material storage device 51 to the monomer release source 20. Accordingly, the coating forming material 201 released by the monomer release source 20 is a vaporized monomer material. The raw material 202 of the coating forming material 201 may be a single or mixed liquid or liquid/solid slurry, and the vaporizer 52 may include an atomizer, and a heating means, an ultrasonic nozzle, or a sprayer. For example, the vaporizer 52 may include a heating means provided to heat the raw material 202 in the transmitting pipe system 53 to produce a vaporized monomer material. The heating means may be provided anywhere in the transmitting pipe system 53. Specifically, the heating means may be provided at a position corresponding to the monomer release source 20, so that when the raw material 202 in liquid state is transmitted to the monomer release source 20, the raw material 202 will be heated by the heating means and produce a vaporized monomer material that is released into the reaction chamber 11.

The raw material 202 of the coating forming material 201 may be powder, and the vaporizer 52 may be a flat jet gas jet vaporizer. In addition, a carrier gas may also be supplied together with the coating forming material 201. The number of the material storage device 51, the vaporizer 52, the transmitting pipe system 53, and the monomer release source 20 is not limited, and one or more of the material storage devices 51, the vaporizers 52, the transmitting pipe systems 53, and the monomer release sources 20 may be applied in some embodiments.

The discharge types of the plasma excitation source 30 include, but are not limited to, direct current discharge, alternating current discharge, audio frequency discharge, radio frequency discharge by capacitive coupling or inductive coupling, resonant cavity microwave discharge, surface wave coupling or electron cyclotron resonance, medium frequency discharge, panning discharge, spark discharge, and pulse discharge. Additionally, the plasma excitation source 30 may be operated to discharge continuously or in pulses.

As shown in FIGS. 2A and 2B, the plasma excitation source 30 includes an electrode means 31 for generating an electric field in the reaction chamber 11 for generating plasma in the reaction chamber 11 of the chamber body 10. In this preferred embodiment, the electrode means 31 includes a first electrode 311 and a second electrode 312 between which a release field 313 is defined. As an example, a pair of electrodes 311 and 312 of this preferred embodiment are provided as positive and negative electrodes in the reaction chamber 11 of the chamber body 10 at a position away from the monomer release source 20, and are connected to an energy source such as an RF generator placed outside the chamber. Optionally, the first electrode 311 may be electrically connected to the energy source, and the second electrode 312 may be grounded. Preferably, each of the first electrode 311 and the second electrode 312 may be implemented as a porous electrode having a plurality of holes communicating with the release field 313 in the reaction chamber 11.

The coating forming material 201 itself may be used as a plasma source gas. In addition, the coating apparatus may further include a plasma source gas supply unit for supplying a plasma source gas, including but not limited to inert gases and nitrogen, into the reaction chamber 11 of the chamber body 10. Before the monomer release source 20 supplies the coating forming material 201 into the reaction chamber 11, a plasma source gas may be injected into the reaction chamber 11 to generate plasma under the effect of the plasma excitation source 30, thereby providing a plasma environment. In addition, the carrier gas may be used as a plasma source gas, and introduced into the reaction chamber 11 to generate plasma before the coating forming material 201 is supplied into the reaction chamber 11.

It is remarkable that, those skilled in the art are able to understand that, one or more additional release sources for releasing the coating forming material 201 may be arranged in the chamber body 10 in such a manner that the plasma excitation source 30 is at a position between the substrate 90 and the additional release source(s) for releasing the coating forming material 201. In these embodiments, a portion of the coating forming material 201 passes through the monomer release source 20 and is released by the monomer release source 20 at a position adjacent to the substrate positioning area 12 of the chamber body. And another portion of the coating forming material 201 is released by an additional release source and passes through the plasma excitation source 30 before reaching the substrate 90, so that not all of the coating forming material 201 is excited by the plasma excitation source 30, in order to prevent all of the coating forming material 201 from being decomposed into small substances.

In addition, the coating apparatus may further include other components, such as a pressure adjusting unit 60 which is adjacent to the plasma excitation source 30 and away from the monomer release source 20 for adjusting the pressure in the reaction chamber 11 of the chamber body 10, a control unit for controlling the operation of the coating apparatus, and a tail gas pipe for collecting the tail gas. In the plasma polymerization coating method of the present disclosure, the reaction chamber 11 is a vacuum chamber under the effect of the pressure adjusting unit 60 before the coating forming material 201 is supplied to the reaction chamber 11. The term "vacuum chamber" means that a chamber has a lower gas pressure than that outside the chamber, and does not necessarily mean that the chamber is evacuated to a vacuum state.

The substrate 90 of the present disclosure includes metals, glasses, ceramics, polymers, fabrics, fibers, powders, and semiconductors, and may be, but is not limited to, electronic components or electronic devices, mechanical parts or mechanical devices, textiles. For example, the electronic components or electronic devices may be, but are not limited to, mobile phones, pagers, radios, speakers, microphones, ringers, buzzers, hearing aids, audio players, televisions, laptops, notebook computers, tablets, keyboards, PCB circuit boards, displays, or sensors. The polymer coating 92 may be, but is not limited to, a hydrophobic coating, a hydrophilic coating, an oleophobic coating, an anti-rust coating, an anti-mildew coating, a moisture-proof coating, an electrically and thermally conductive coating, a biomedical coating, an optical coating, and a friction coating. The surface 91 of the substrate 90 where the polymer coating 92 is deposited may be the entire surface of the substrate 90, or a partial area of the entire surface of the substrate 90.

The polymer coating 92 may be an acrylic coating, an epoxy coating, an organosilicone coating, a polyurethane coating, or a p-xylene coating. A typical polymer coating 92 is a hydrophobic polymer coating. And, the coating forming material 201 includes CF3-based perfluorinated compounds, perfluoroolefins, hydrogen-containing unsaturated compounds, optionally substituted alkynes, polyether-substituted olefins, organic compounds containing two double bonds, saturated organic compounds having an optionally substituted alkyl chain of at least 5 carbon atoms which can be optionally intercalated with a heteroatom, and a macrocycle containing at least one heteroatom.

The coating forming material 201 may be a monomer of a single molecule, an oligomer, or a combination thereof, for example, the oligomer may be a bipolymer, such as, parylene C, and parylene N, and the like. As an example of the coating forming material 201, the monomer is a mixture of one or more monofunctional unsaturated fluoro-substituted compounds and one or more polyfunctional unsaturated hydrocarbon derivatives. The fluoro-substituted compounds include, but are not limited to, 3-(perfluoro-5-methylhexyl)-2-hydroxypropyl methacrylate, 2-(perfluorodecyl)ethyl methacrylate, 2-(perfluorohexyl)ethyl methacrylate, 1,1,2,2-tetrahydroperfluorotetradecyl acrylate, 1H, 1H, 2H, 2H-heptadecafluorodecyl acrylate, 1H, 1H, 2H, 2H-perfluorooctyl acrylate, 2-(perfluorobutyl)ethyl acrylate, (2H-perfluoropropyl)-2-acrylate, (perfluorocyclohexyl)methyl acrylate, 1-propinyl,3,3,3-trifluoro-, 1-ethynyl-3,5-difluorobenzene, and 4-ethynyl-trifluorotoluene. The polyfunctional unsaturated hydrocarbon derivatives include, but are not limited to, ethoxylated trimethylolpropane triacrylate, tripropylene glycol diacrylate, divinylbenzene, poly (ethylene glycol) diacrylate, 1,6-hexanediol diacrylate, ethylene glycol diacrylate, diethylene glycol divinyl ether, and neopentyl glycol diacrylate.

As another example, the polymer coating 92 is formed on the surface 91 of the substrate 90 to protect the surface 91 from chemical corrosion and enhance hydrophobicity property. More specifically, the monomer has a structure represented by the following formula: 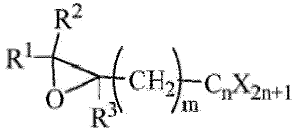 wherein R₁, R₂, and R₃ are hydrophobic groups and are independently selected from hydrogen, alkyl, halogen, or haloalkyl, and wherein m is an integer from 0 to 8, n is an integer from 1 to 15, and X is H or halogen, and further, X is halogen F.

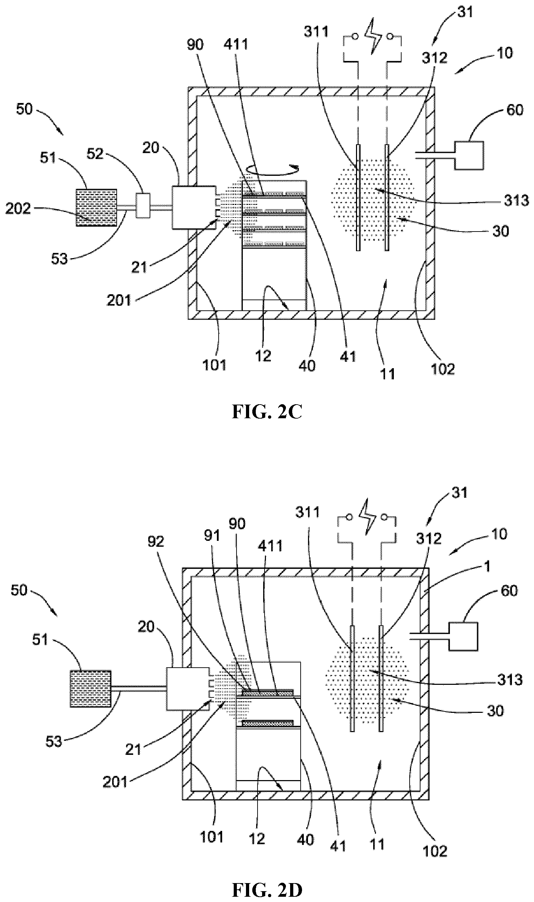

As shown in FIG. 2C, a feasible mode of the coating apparatus according to the above first preferred embodiment is illustrated. The support frame 40 is movably provided in the reaction chamber 11 of the chamber body 10. In a specific embodiment, the support frame 40 is operable to rotate about a central axis thereof, so that the position of the substrate 90 in the reaction chamber 11 is adjustable, so as to adjust the distance between the substrate 90 and the plasma excitation sources 30 and thus the distance between the substrate 90 and the monomer release source 20, to control and adjust the composition of formed polymer materials deposited on the surface 91 of the substrate 90.

According to the above first preferred embodiment, as shown in FIG. 2D, there is another feasible mode of the coating apparatus. In the embodiment, the monomer supply unit 50 includes a material storage device 51 for storing a gaseous raw material of the coating forming material 201, and no vaporizer is required. In other words, the coating forming material 201 is stored in the material storage device 51 and is directly sent to the monomer release source 20 through the transmitting pipe system 53.

For example, the coating apparatus of this preferred embodiment may be used to form a DLC (diamond-like carbon) coating on the surface 91 of the substrate 90. The coating forming material 201 mainly composed of gaseous hydrocarbons is directly introduced into the reaction chamber 11 of the coating apparatus to perform a PECVD process.

Correspondingly, the present disclosure provides a coating method for coating the substrate 90 by the coating apparatus, and the coating method includes the following steps:
(a) arranging the substrate 90 in the reaction chamber 11 of the chamber body 10 at a position between the monomer release source 20 and the plasma excitation source 30; and
(b) introducing the coating forming material 201 into the reaction chamber 11 through the monomer release source 20 to perform a PECVD process, so as to form the polymer coating 92 on the surface 91 of the substrate 90 under the effect of the plasma excitation source 30.

The step (a) may include a step of placing one or more of the substrates 90 at the substrate positioning area 12 of the chamber body, wherein the monomer release source 20 and the plasma excitation source 30 are respectively provided on two sides of the one or more of the substrates 90.

Feasibly, the step (a) may include a step of placing one or more of the substrates 90 on the support frame 40, and placing the support frame 40 together with the substrate(s) 90 at the substrate positioning area 12 of the chamber body, wherein the monomer release source 20 and the plasma excitation source 30 are respectively disposed on two sides of the support frame 40.

Optionally, the step (a) may include a step of constructing the support frame 40 at the substrate positioning area 12 in the reaction chamber 11 of the chamber body 10, and loading the support frame 40 with one or more of the substrates 90, wherein the support frame 40 may be configured and secured in the chamber body 10, or just placed in the reaction chamber 11.

It is remarkable that one or more of the substrates 90 may be horizontally, obliquely, or vertically placed in the reaction chamber 11 of the chamber body 10.

In the step (a), the coating method includes a step of arranging the monomer release source 20 and the plasma excitation source 30 at intervals in the reaction chamber 11 on two opposite sides of the reaction chamber 11 of the chamber body 10, and placing one or more of the substrates 90 in a flow path of the coating forming material 201 from the monomer release source 20 to the plasma excitation source 30, in such a manner that at least a portion of the coating forming material 201 has to pass through the substrate positioning region 12 where the substrate is placed, before reaching the plasma excitation source 30.

The step (b) may include a step of vaporizing the raw material 202 to form the coating forming material 201 as a vaporized monomer, and transmitting the coating forming material 201 to the monomer release source 20 to supply the coating forming material 201 into the reaction chamber 11 of the chamber body 10. Accordingly, the coating forming material 201 may be pumped into the reaction chamber 11, or sucked into the reaction chamber 11 due to a decrease in pressure of the reaction chamber 11.

The step (b) may include a step of supplying the coating forming material 201 as a gaseous monomer to the monomer release source 20 to supply the coating forming material 201 into the reaction chamber 11 of the chamber body 10.

According to this preferred embodiment, in the step (b), as shown in FIG. 2B, the coating forming material 201 is dispersed into the chamber body 10 through the monomer release source 20 toward the plasma excitation source 30. For example, the coating forming material 201 is injected horizontally into the chamber body 10 toward the plasma excitation source 30, but the support frame 40 is arranged between the monomer release source 20 and the plasma excitation sources 30, the coating forming material 201 is not required to pass through the plasma excitation source 30 before reaching the substrate 90 for plasma processing the substrate 90, so that not all the coating forming material 201 is activated and excited by the plasma excitation source 30.

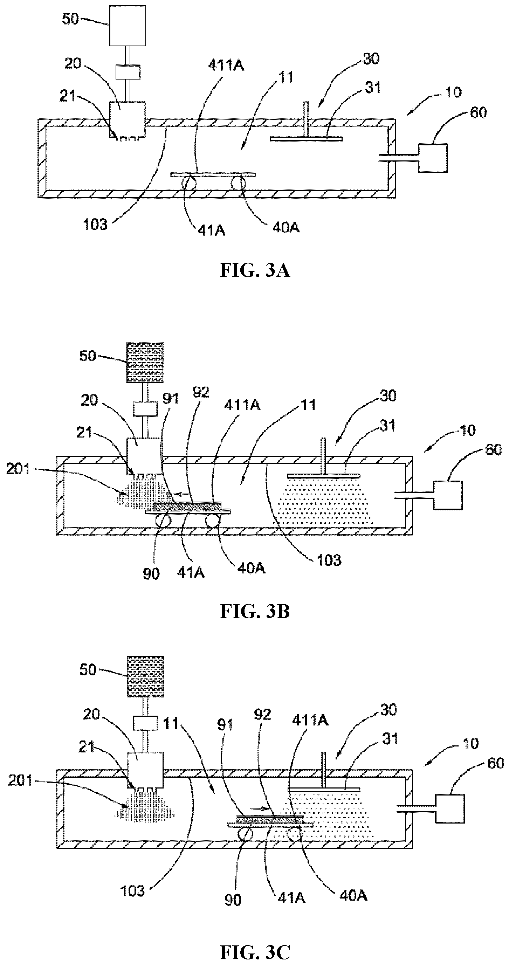

As shown in FIGS. 3A to 3C, a coating apparatus according to a second preferred embodiment of the present disclosure is illustrated. The coating apparatus of this preferred embodiment includes a chamber body 10 having a reaction chamber 11, a monomer release source 20 for releasing a gaseous coating forming material 201 into the reaction chamber 11 of the chamber body 10, a plasma excitation source 30 far away from the reaction chamber 11 and operable to activate and excite the coating forming material 201, and a support frame 40Afor supporting and carrying a substrate 90 on a support area 411A, thereby when the plasma excitation source 30 is operated, and the coating forming material 201 is injected into the reaction chamber 11, the substrate 90 is exposed to the plasma generated by the plasma excitation source 30 to allow the polymer coating 92 to be deposited and formed on the surface 91 of the substrate 90 .

According to this preferred embodiment, the support frame 40A is implemented as a support movable in the reaction chamber 11 of the chamber body 10. In particular, the support frame 40A is movable between the monomer release source 20 and the plasma excitation source 30. The movement pattern of the support frame 40 may be, but is not limited to, linear movement, curvilinear movement, sliding movement, or rotational movement, so that the position of the substrate 90 in the reaction chamber 11 is adjusted, thereby adjusting the amount of the monomer and decomposed precursors deposited on the substrate 90, so as to improve the quality of the polymer coating 92 formed on the surface 91 of the substrate 90. In some embodiments, the movement of the support frame 40A provides a substantially same plasma polymerization environment for a plurality of the substrates 90 to enhance the uniformity of the polymer coating 92 formed on the substrates 90.

The movement of the support frame 40A may be configured to produce relative displacement between the substrate 90 and the monomer release source 20, or relative displacement between the substrate 90 and the plasma excitation source 30, or equivalent states of the above two, so that the amount of the monomer not excited by the plasma excitation source 30 or the amount of the reactive precursor species generated by decomposing the monomer, which reaches the substrate 90, may be adjusted to ensure a sufficient reaction between the monomer and the reactive precursor species.

It is remarkable that, the movement of the support frame 40A may be controlled by a control unit programmed to adjust movement, movement time interval, or movement speed to provide a desired plasma polymerization environment for the substrate 90, to obtain desired branching and crosslinking in the molecular structure of the polymer coating 92 and form a polymer coating 92 with relatively high quality.

According to this preferred embodiment, as shown in FIGS. 3A to 3C, the support frame 40A is embodied as a movable support capable of repeatedly moving between the monomer release source 20 and the plasma excitation source 30, so as to adjust the distance between the substrate 90 and the monomer release source 20, as well as the distance between the substrate 90 and the plasma excitation source 30.

In a specific embodiment, the chamber body 10 has a rectangular reaction chamber 11, and the monomer release source 20 and the plasma excitation source 30 are provided on the same side wall of the chamber body 10 and spaced apart from each other. For example, the monomer release source 20 and the plasma excitation source 30 are arranged at a top side wall 103 of the chamber body 10. In the plasma polymerization coating method, the monomer release source 20 releases the coating forming material 201, and a monomer area is defined in front of the monomer release source 20, the plasma excitation source 30 forms a plasma generating area therearound during operation, and the support frame 40A moves back and forth between the monomer area and the plasma generating area.

As shown in the figures, in this preferred embodiment, the coating forming material 201 is not dispersed into the reaction chamber 11 through the monomer release source 20 toward the plasma excitation source 30, but may be introduced into the reaction chamber 11 laterally, and then dispersed to the substrate 90 and the plasma excitation source 30 in the longitudinal direction, so that the air flow of the coating forming material 201 released by the monomer release source 20 will not be directly blown to the plasma generated around the plasma excitation source 30, making the reactive precursor species decomposed from the monomer and the monomer have ideal mixing properties.

Those skilled in the art will appreciate that, the support frame 40A operable to move between the monomer release source 20 and the plasma excitation source 30 may be driven by an electric motor, a pneumatic drive system, or a hydraulic drive system. The chamber body 10 may be provided with a guide rail or a guide groove for holding the support frame 40A in place and for guiding and restricting the movement of the support frame 40A.

As shown in the figures, the electrode means 31 of the plasma excitation source 30 in this preferred embodiment is configured as a planar electrode extending in the reaction chamber 11, and may also be other electrode means for generating an electric field.

Accordingly, this preferred embodiment of the present disclosure provides a coating method for depositing the polymer coating 92 on the surface 91 of the substrate 90 including the following steps:
(A) supplying the coating forming material 201 to the reaction chamber 11 of the chamber body 10 through the monomer release source 20 away from the plasma excitation source 30;
(B) moving the substrate 90 between the monomer release source 20 and the plasma excitation source 30; and
(C) activating the plasma excitation source 30 to treat the substrate 90 with plasma to form the polymer coating 92 on the surface 91 of the substrate 90.

It should be noted that, the order of the above steps (A), (B) and (C) is not limited. In the step (B), the step may include a step of carrying the substrate 90 on the support frame 40A, and driving the support frame 40A to move back and forth repeatedly between the monomer release source 20 and the plasma excitation source 30. As a preferred example, the support frame 40A is driven to move to adjust the distance between the substrate 90 and the monomer release source 20, as well as the distance between the substrate 90 and the plasma excitation source 30.

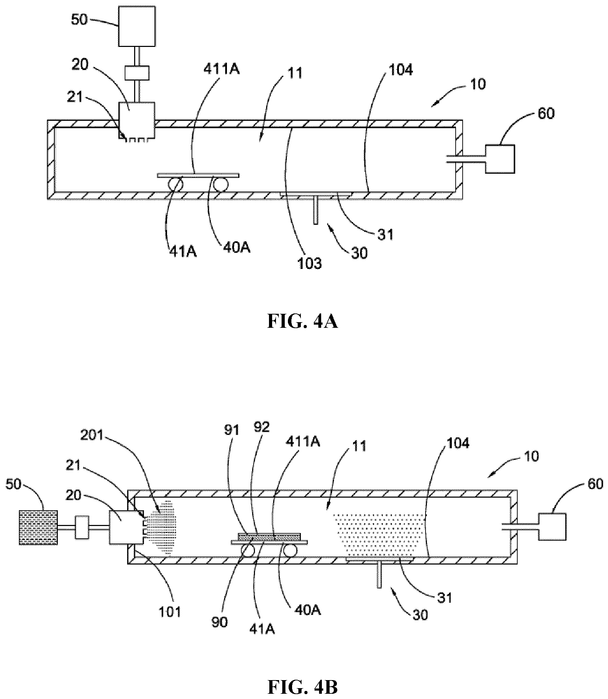

As shown in FIG. 4A, in another feasible mode, the monomer release source 20 and the plasma excitation source 30 may be arranged adjacent to two opposite side walls of the chamber body 10. For example, the monomer release source 20 is arranged adjacent to a top side wall 103, and the plasma excitation source 30 is configured on a bottom side wall 104 of the chamber body 10. As shown in FIG. 4B, as another feasible mode, the monomer release source 20 may be provided adjacent to one end side wall 101 of the chamber body 10 for releasing the coating forming material 201 to the substrate 90, and the plasma excitation source 30 may be arranged at a bottom wall 104 of the chamber body 10. In other words, the monomer release source 20 and the plasma excitation source 30 may be arranged on adjacent side walls 101 and 104 of the chamber body 10.

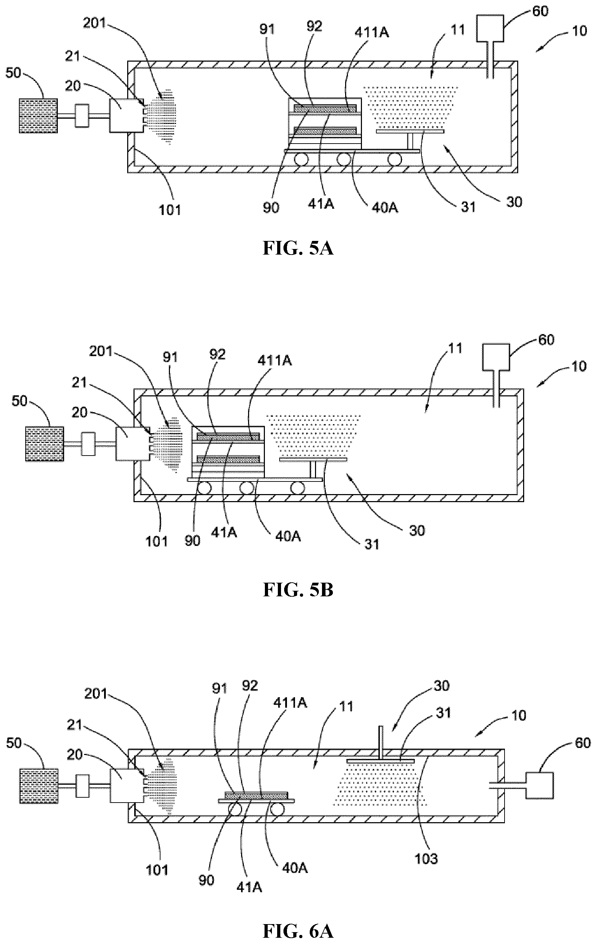

As shown in FIGS. 5A and 5B, in the above preferred embodiment, the plasma excitation source 30 may be configured on one side of the support frame 40A as still another feasible mode, opposite to the monomer release source 20. The support frame 40A is immovable, or preferably, the support frame 40A is configured to be movable to adjust the distance between the support frame 40A and the monomer release source 20, as well as the distance between the monomer release source 20 and the plasma excitation source 30. According to this preferred embodiment, the relative position between the substrate 90 and the plasma excitation source 30 may be fixed, but the plasma excitation source 30 is movable together with the support frame 40A, to change the plasma generating environment in the reaction chamber 11 of the chamber body 10.

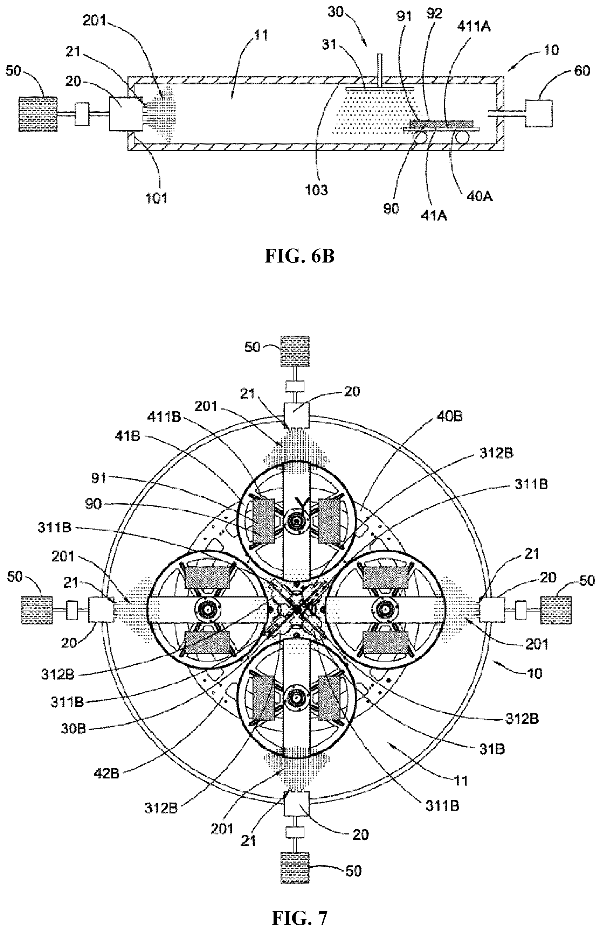

As shown in FIGS. 6A and 6B, another optional mode of the coating apparatus is illustrated. In the embodiment, those skilled in the art should understand that, the support frame 40A is also movable to a certain position in a manner that the plasma excitation source 30 is located between the monomer release source 20 and the substrate 90. However, during the movement of the support frame 40A between the monomer release source 20 and the plasma excitation source 30, the coating forming material 201 has to pass through the support frame 40A before reaching the plasma excitation source 30, so that not all the coating forming material 201 is required to pass through the plasma excitation source 30 before reaching the substrate 90.

In other words, this preferred embodiment provides a coating method for depositing the polymer coating 92 on the surface 91 of the substrate 90, including the following steps:
moving the substrate 90 in the reaction chamber 11 of the chamber body 10, thereby defining a moving path of the substrate 90, wherein on at least a part of the movement path, the substrate 90 is located at a position between the monomer release source 20 and the plasma excitation source 30; and
releasing the coating forming material 201 into the reaction chamber of the chamber body 10 to activate the plasma to treat the substrate 90 during operation of the plasma excitation source 30.

Accordingly, the movement path of the substrate 90 may include a first part and a second part. In the first part, the monomer release source 20 and the plasma excitation source 30 are located on two sides of the substrate 90, respectively. In the second part, the monomer release source 20 and the substrate 90 are located on two sides of the plasma excitation source 30, respectively. And, the first part of the movement path of the substrate 90 carried by the support frame 40A may be significantly larger than the second part.

A coating apparatus according to a third preferred embodiment of the present disclosure is shown in FIG. 7. More specifically, the coating apparatus of this preferred embodiment includes a chamber body 10 having a reaction chamber 11, one or more monomer release sources 20 for releasing a gaseous coating forming material 201 into the reaction chamber 11 of the chamber body 10, a plasma excitation source 30 for exciting the coating forming material 201, and a support frame 40B for supporting and transporting the substrate 90, so that when the plasma excitation source 30B is in operation and the coating forming material 201 is fed into the reaction chamber 11 by one or more of the monomer release sources 20, the polymer coating 92 is deposited and formed on the surface 91 of the substrate 90.

According to this preferred embodiment, the plasma excitation source 30B is arranged at a substantially central area of the support frame 40B. Preferably, the plasma excitation source 30B may be arranged in the center of the reaction chamber 11 of the chamber body 10, and a plurality of the substrates 90 on which the polymer coating 92 is to be deposited are adapted to be arranged around the plasma excitation source 30B. The substrate 90 is adapted to surround the plasma excitation source 30B, such that the substrate 90 is adapted to be arranged between the plasma excitation source 30B and the monomer release source 20.

Specifically, a plurality of the monomer release sources 20, for example, four of the monomer release sources 20 may be arranged at a position adjacent to the inner wall of the chamber body 10, and the coating forming material 201 may be released at a position adjacent to the inner periphery of the chamber body 10 and flow toward the plasma excitation source 30B located at the center of the chamber body 10. Since the plurality of the monomer release sources 20 and the plasma excitation source 30B are provided on two opposite sides of the substrate 90, excessive decomposition of the coating forming material 201 is prevented.

The plasma excitation source 30B of this preferred embodiment of the present disclosure includes an electrode means 31B for applying electric power to the coating forming material 201 released into the chamber body 10. More specifically, as an example, the electrode means 31B includes at least one pair of electrodes, in some embodiments, multiple pairs of first electrodes 311B and second electrodes 312B are provided in the center of the reaction chamber 11. As shown in FIG. 7, each of the first electrode 311B and the second electrode 312B may be respectively implemented as an elongated electrode plate vertically arranged in the reaction chamber 11 of the chamber body 10. In the exemplary example, four of the first electrodes 311B and four of the second electrodes 312B are alternately arranged in a circumferential direction.

The first electrode 311B and the second electrode 312B are positive and negative electrodes, and are respectively electrically connected to two connection ends of an energy source such as an RF generator located outside the chamber body 10. Optionally, the first electrode 311B may be electrically connected to an energy source, and the second electrode 312B may be grounded.

The support frame 40B of this embodiment includes one or more carrier frames 41B for carrying one or more of the substrates 90. Each of the carrier frames 41B has a support area 411B for positioning the substrate 90, and the substrate 90 may be horizontally, obliquely, and vertically placed on the support area 411B. In this embodiment, the substrate 90 may be horizontally placed at the support area 411B, and held and supported by the support area 411B.

According to this preferred embodiment, a plurality of the support areas 411B of one or more carrier frames 41B are provided between the plasma excitation source 30B and the monomer discharge source 20, so that when one or more of the substrates 90 is placed on the corresponding support area 411B, the monomer release source 20 and the plasma excitation source 30B are respectively arranged on two opposite sides of each corresponding substrate 90.

In addition, each of the carrier frames 41B of the support frames 40B of this preferred embodiment may carry a plurality of the substrates 90 and is movable in the reaction chamber 11, and the movement pattern of each carrier frame 41B may be, but is not limited to, linear motion, curvilinear motion, sliding motion, and rotational motion. As a specific example of this preferred embodiment, each of the carrier frames 41B of the support frames 40B is operable to rotate about a central axis Y thereof.

The support frame 40B of this embodiment further includes a movable frame 42B for supporting one or more carrier frames 41B. The movement of the movable frame 42B may also be, but is not limited to, linear motion, curvilinear motion, sliding motion, and rotational motion.

According to this preferred embodiment, the movable frame 42B is used as a rotating frame, and may be implemented to rotate about the central axis X in the reaction chamber of the circular chamber. And, since the carrier frame 41B is supported on the movable frame 42B, and each carrier frame may move with the movable frame 42B while rotating relative to a central axis Y thereof, so that the two movements of the carrier frame 41B change the relative position between each of the substrates 90 and the plasma excitation source 30.

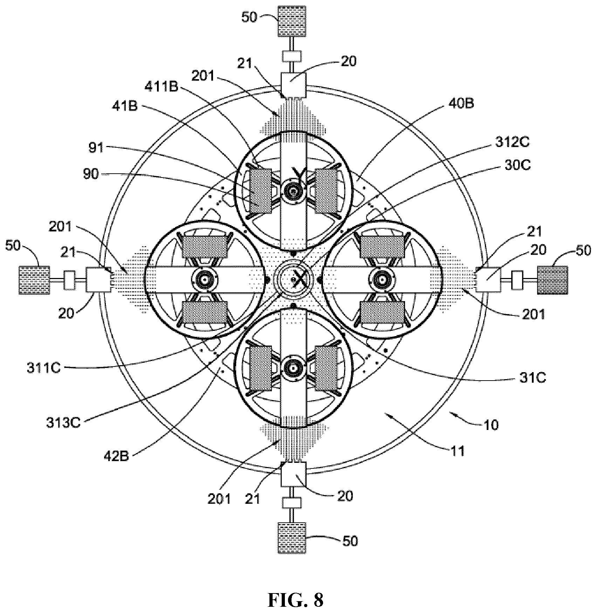

As shown in FIG. 8, as a feasible mode of the above third preferred embodiment of the present disclosure, the coating apparatus includes a plasma excitation source 30C including an electrode means 31C. The electrode means 31C of this preferred embodiment includes a first electrode 311C and a second electrode 312C, each electrode is implemented as a cylindrical electrode, and the first electrode 311C is sheathed around the second electrode 312C, so that a circular release field 313C is defined between the first electrode 311C and the second electrode 312C. The first electrode 311C may be electrically connected to an energy source, such as an RF generator, and the second electrode 312C may be grounded.

In addition, the first electrode 311C may be implemented as a porous electrode having a plurality of holes connected to the release field 313C in the reaction chamber 11. The second electrode 312C is formed as an elongated tube having a communication hole communicating with the reaction chamber 11, so that the second electrode 312C may also be used as a pumping pipe communicated with the outer side of the reaction chamber 11 of the chamber body for pumping a gas mixture from the reaction chamber 11 of the chamber body 10, so as to adjust the pressure in the reaction chamber 11 and remove the exhaust gas in the reaction chamber 11.

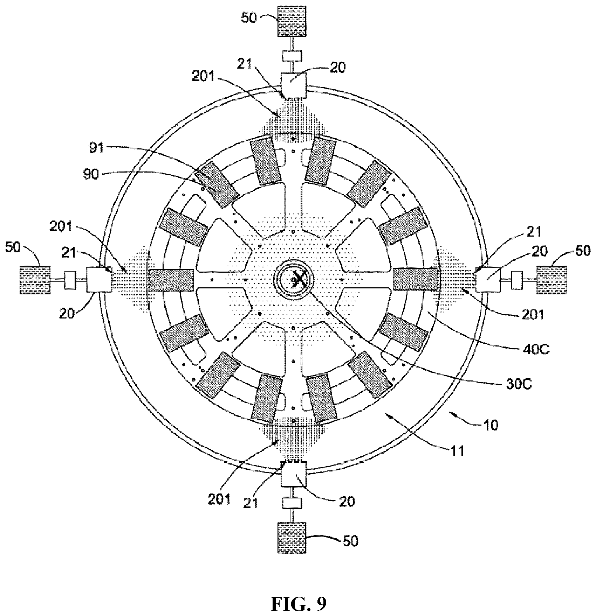

As shown in FIG. 9, according to another feasible mode of the above preferred embodiment of the present disclosure, the coating apparatus includes the plasma excitation source 30C and a support frame 40C. In this preferred embodiment, the support frame 40C is used as a rotating frame capable of rotating around a central axis X thereof, and a plurality of the substrates 90 may be directly placed on the support frame 40C without the carrier frame 41B. The movement of the plurality of the substrates 90 is caused by the rotation of the support frame 40C.

According to this preferred embodiment of the present disclosure, the coating method for depositing the polymer coating 92 on the surface 91 of each of the plurality of the substrates 90 includes the following steps:
(α) surrounding the plasma excitation source 30B/30C by a plurality of the substrates 90, and disposing the monomer release source 20 and the plasma excitation source 30B/30C on two opposite sides of the substrates 90; and
(β) releasing the coating forming material 201 to the reaction chamber 11 of the chamber body 10, to perform a plasma processing on the substrates 90 by the plasma excitation source 30B/30C.

Accordingly, in the step (α), the plasma excitation source 30B/ 30C is arranged on the inner side of the substrate 90, and the monomer release source 20 is arranged on the outer side of the substrate 90. The plasma excitation source 30B/30C may be arranged in the central area of the reaction chamber 11, and the substrate 90 surrounds the plasma excitation source 30B/30C.

In the step (β), at least a portion of the coating forming material 201 is required to pass through the support frame 40B/40C carrying the substrate 90 before reaching the plasma excitation source 30B/30C.

The step (β) may further include a step of circumferentially arranging various monomer release sources 20 in the central area of the reaction, and radially releasing the coating forming material 201 into the reaction chamber 11 of the chamber body 10 by the monomer release sources 20 toward the plasma excitation source 30B/30C.

The coating method may further include a step of rotating a rotating frame 42B around the central axis X and rotating the carrier frame 41B around the central axis Y, wherein each of the carrier frames 41B used to carry the substrates 90 is supported on the rotating frame 42B and rotates about the axis X together with the rotating frame 42B while rotating about its own axis Y.

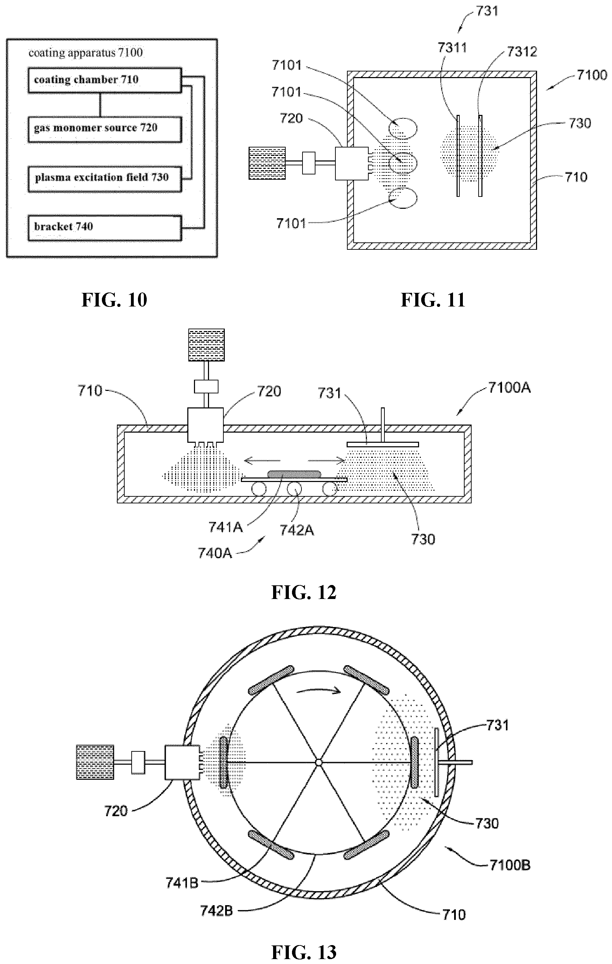

FIGS. 10 and 11 show a coating apparatus 7100 according to a fourth preferred embodiment of the present disclosure, wherein the coating apparatus 7100 includes a coating chamber 710, at least one monomer source 720, and a plasma excitation field 730, wherein the coating chamber 710 has a coating area 7101 for placing a substrate, wherein the monomer source 720 is communicated with the coating chamber 710 and used for supplying a monomer to the coating chamber 710, and wherein the plasma excitation field 730 is provided in the coating chamber 710 and used for activating a monomer, wherein the plasma excitation field 730 and the monomer source 720 are respectively located on two sides of the coating area 7101 to prepare a thin coating on a surface of the substrate. In this embodiment, the chamber body is implemented as the coating chamber 710, the monomer release source is implemented as the monomer source 720, and the plasma excitation source is implemented as the plasma excitation field 730.

During the coating process, a plasma environment is provide by passing a plasma source gas into the coating chamber 710, wherein the plasma excitation field 730 discharges to generate plasma, and wherein the gas monomer enters the plasma excitation field 730 through the coating area 7101 to be activated, so as to avoid the phenomenon of molecular chain structure being fragmented or excessively decomposed, etc. due to direct excessive activation of gas monomers in the plasma excitation field 730, so as to prepare a thin coating or coating with a relatively good property on the surface of the substrate. In other words, the gas monomer first diffuses into the coating area 7101, and then diffuses into the plasma excitation field 730, after being charged into the coating chamber 710. The plasma diffuses toward the coating area 7101. The gas monomer diffuses into the plasma excitation field 730 to be activated, and the activated gas monomer then diffuses to the coating area 7101 and is deposited on the surface of the substrate together with the unactivated gas monomer, to form a thin coating or coating with a relatively good property, and increase the deposition speed at the same time.

Further, the concentration of the gas monomer or monomer vapor diffusing along the radial direction of the coating area 7101 is gradually reduced, and in the same direction, the concentration of the plasma generated by discharge of the plasma excitation field 730 diffusing along the radial direction of the coating area 7101 is gradually increased, so that the concentration of the activated monomer is kept stable, so as to prepare a high-quality thin coating or coating on the surface of the substrate.

The coating apparatus 7100 applies the plasma chemical vapor deposition method to prepare the thin coating or coating on the surface of the substrate. That is, the thin coating is deposited and formed on the surface of the substrate, so as to improve the mechanical, optical or chemical properties of the surface of the substrate, wherein the substrate such as a product to be coated with a predetermined shape and structure, such as PCB circuit boards, mobile phones, electronic devices, electronic product covers, electronic product display screens, mobile phone glass screens, computer screens, mobile phone back covers, electronic equipment shells, keyboard coatings or mechanical parts, clothing and other types of products to be coated etc., is not limited thereto. For example, the coating apparatus prepares on an electronic product the thin coating, which is able to effectively improve waterproof, corrosion resistant, wear resistant and other protective properties of the product and solve the problem of high surface protection cost.

Optionally, the thin coating includes one or more layers of coatings, thin coatings, or nanocoatings, etc. coated on the surface of the substrate. Optionally, the thin coating or coating may be an inorganic thin coating, an organic thin coating, an organic silicon nano-protective coating, an organic silicon hard nano-protective coating, a composite structure high-insulation hard nano-protective coating, a high-insulation nano-protective coating with a modulated structure, a plasma polymerized coating, a gradient increasing structure liquid-proof coating, a gradient decreasing structure liquid-proof coating, a coating with controllable crosslinking degree, a waterproof and anti-puncture coating, a low adhesion and corrosion resistant coating, a liquid-proof coating with multi-layer structure, a polyurethane nanocoating, an acrylamide nanocoating, an anti-static liquid-proof nanocoating, an epoxy nanocoating, a high-transparency low-chromatic aberration nanocoating, a high-adhesion aging resistant nanocoating, a silicon-containing copolymer nanocoating, or a polyimide nanocoating, a diamond-like coating, etc., and is not limited herein. Alternatively, according to the definition of IPC, the coating or thin coating may be AR (acrylic), ER (epoxy), SR (organosilicon), UR (polyurethane), and XY (paraxylene) and other types of coatings or thin coatings. Further, paraxylene or parylene type coatings may provide relatively good chemical, electrical or physical protection.

The feed port of the monomer source 720 is communicated with the side of the coating chamber 710 close to the coating area 7101, that is, on the opposite side of the plasma excitation field 730, so as to ensure that the diffusion path of the gas monomer or monomer vapor is from the coating area 7101 to the plasma excitation field 730.

Optionally, the composition of the monomer is a mixture of at least one monofunctional unsaturated fluorocarbon compound and at least one multifunctional unsaturated hydrocarbon derivative or an organosilicon monomer containing a double bond, Si-Cl, Si-O-C, Si -N-Si, Si-O-Si structure or cyclic structure, the mass fraction of the polyfunctional unsaturated hydrocarbon derivatives in the monomer is 30-50%, wherein, the monofunctional unsaturated fluorocarbon compound includes 3-(perfluoro-5-methylethyl)-2-hydroxypropyl methacrylate, 2-(perfluorodecyl)ethyl methacrylate, 2-(perfluoroethyl)ethyl methacrylate, 2-(perfluorododecyl)ethyl acrylate, 2-perfluorooctyl ethyl acrylate, 1H, 1H, 2H, 2H-perfluorooctane alcohol acrylate, 2-(perfluorobutyl)ethylacrylate, (2H-perfluoropropyl)-2-acrylate, (perfluorocycloethyl)methacrylate, 3,3,3-trifluoro-1-propyne, 1-ethynyl-3,5-difluorobenzene, or 4-ethynyl trifluorotoluene. The polyfunctional unsaturated hydrocarbon derivative includes ethoxylated tricarboxymethyl propane triacrylate, tripropylene glycol diacrylate, divinylbenzene, polyethylene glycol diacrylate, 1,6-ethylene glycol diacrylate, ethylene glycol diacrylate, diethylene glycol divinyl ether, or neopentyl glycol diacrylate, and the multifunctional unsaturated hydrocarbon derivative includes polyethylene glycol diacrylate, ethylene glycol diacrylate, and diethylene glycol divinyl ether, ethoxylated trimethylolpropane triacrylate, tripropylene glycol diacrylate, 1,6-hexanediol diacrylate, or neopentyl glycol diacrylate.

Optionally, the monomer includes carbon-containing compounds with a reactive functional group, further includes substantially -CF3-based perfluoro compounds (see WO 97/38801), perfluoroolefins (see Wang et al., Chem Mater 1996, 2212-2214). Optionally, the monomer may also include hydrogen-containing unsaturated compounds containing a halogen atom or perhalogenated organic compounds containing at least 10 carbon atoms (see WO 98/58117), organic compounds containing two double bonds (see WO 99/64662), a saturated organic compound with an alkyl chain (optionally inserted with a heteroatom) of at least 5 carbon atoms (see WO 00/05000), an alkyne (see WO 00/20130), polyether substituted olefins (see US6482531B), or macrocycles containing at least one heteroatom (see US6329024B).

Optionally, the thin coating is a diamond-like thin coating (DLC thin coating). The gas monomer for preparing the DLC thin coating is a reactive gas such as hydrogen, a hydrocarbon gas, or a dielectric material or an auxiliary gas of a doping element such as N, Si, F, B, etc. For example, the hydrocarbon gas is, such as, an alkane, an alkene, an alkyne, and the like, having a carbon atom number of 1-6 or more, not limited hereto. Optionally, the plasma excitation field 730 is located in the middle area or position of the coating chamber 710, wherein the feed port of the monomer source 720 may be located at a position of the surrounding sides of the coating chamber 710. The feed port may be multiple, and may be evenly arranged on the surrounding sides of the coating chamber 710, wherein the coating area 7101 is located between the middle position of the coating chamber 710 and the surrounding sides.

Optionally, the plasma excitation field 730 is located on one side of the coating chamber 710, wherein the feed port of the monomer source 720 is located on the opposite side of the coating chamber 710. Optionally, the gas source 720 and the plasma excitation field 730 may be arranged side by side with a certain distance therebetween, but not overlapping. Optionally, the coating chamber 710 may be circular, square or other shapes.

Further, the monomer source 720 is a feed source for a gas monomer or monomer vapor to go into the coating chamber, and may be communicated with a gas storage device for storing the gas monomer in a gas state through a transmitting pipeline, so as to pass the gas monomer in a gaseous state into the coating chamber 710. Alternatively, the monomer source 720 may be communicated with a liquid storage device for storing a monomer in a liquid state through a transmitting pipeline, wherein the monomer in a liquid state is vaporized by a gasification device (such as a heating device) to form a monomer vapor in a gas state, and is passed into the coating chamber 710 through the monomer source 720. Optionally, the storage device may be a storage means for storing monomer raw materials, such as, a storage device, a storage bottle, or a storage tank.

The plasma excitation field 730 includes an electrode means 731, wherein the coating apparatus further includes a plasma source, wherein the plasma source is communicated with the coating chamber 710, and used for charging the coating chamber 710 with a plasma source gas, wherein the electrode means 731 is used to provide a radio frequency and/or pulse voltage to discharge the gas to generate a plasma environment. Further, the electrode means 731 and the monomer source 720 are located on two sides of the coating area 7101, respectively, so that the substrate in the coating area 7101 is not directly in the center of the plasma environment, that is, the substrate in the coating area 7101 is located at the edge area or position of the plasma environment generated by the plasma excitation field 730, so as to prevent the gas monomer on the surface of the substrate from being directly excessively activated in the center of the plasma excitation field 730, leading to phenomenons of fragmentation or excessive decomposition of the molecular chain structure, etc., and at the same time, to be capable of preparing a thin coating or coating with a good performance on the surface of the substrate.

The plasma source is communicated with a side of the coating chamber 710 close to the electrode means 731, so as to form the plasma excitation field 730 by discharging at the position of the electrode means 731, wherein the plasma source gas is a plasma source gas, such as, nitrogen, carbon tetrafluoride, or an inert gas such as helium or argon. Optionally, the plasma source is communicated with a pipeline for transmitting a gas. Optionally, the plasma source is further communicated with a storage means for storing a plasma source gas.

Optionally, the discharge types of the electrode means 731 of the plasma excitation field 730 may be a discharge type such as direct current, alternating current, radio frequency, microwave, medium frequency, electric spark or pulse, and the like. For example, the mode in which the plasma excitation field 730 applies radio frequency discharge may be capacitive coupling and inductive coupling. For example, the mode in which the plasma excitation field 730 applies microwave discharge may be a resonant cavity, surface wave coupling, and electron cyclotron resonance. For example, the discharge mode of the plasma excitation field 730 may be continuous discharge or pulse discharge.

Preferably, the electrode means 731 includes a first electrode 7311 and a second electrode 7312, wherein a radio frequency voltage is provided between the first electrode 7311 and the second electrode 7312. For example, the electrode means 731 is used to provide a radio frequency voltage, wherein the first electrode 7311 is a radio frequency electrode, and is used to provide a radio frequency voltage, and the second electrode 7312 is a ground electrode. That is to say, the area between the first electrode 7311 and the second electrode 7312 generates a relatively strong RF voltage, while the RF voltage in the surrounding area is relatively low, that is, the coating area 7101 is located in a weak plasma environment to avoid excessive activation or decomposition of the gaseous monomer or monomer vapor, etc.

Further, the first electrode 7311 and the second electrode 7312 are facing each other and have a certain facing area, so as to form the plasma excitation field 730 with a certain space area, so that the plasma gas source gas discharges between the electrodes of the plasma excitation field 730 and generates plasma.

Further, the electrode means 731 further includes a pulse power supply, wherein the pulse power supply is provided in the coating chamber 710, wherein the pulse power supply is used to provide a pulse voltage to effect on the activated gas to accelerate the deposition rate, and improve the coating efficiency.

Optionally, the electrode means 731 is a microwave discharge electrode for generating a microwave discharge to effect on the plasma source gas to generate a plasma environment. Optionally, the electrode means 731 is a medium frequency discharge electrode for generating a plasma environment through medium frequency discharge. Optionally, the electrode means 731 is an electric spark discharge electrode for generating a plasma environment through electric spark discharge.

Further, the coating apparatus 7100 further includes a bracket 740, that is, the above support frame is implemented as the bracket 740 in this embodiment, wherein the bracket 740 is provided in the coating area 7101 for supporting the substrate. In this embodiment, the bracket 740 is detachably fixed to the coating area 7101, that is, the bracket 740 is fixed between the feed port of the monomer source 720 and the electrode means 731 of the plasma excitation field 730.

Further, the pulse power supply includes a positive electrode and a negative electrode, wherein the negative electrode is provided on the bracket 740 to provide a negative pulse voltage, wherein the positive electrode is connected to the coating chamber 710 and grounded to provide a positive pulse voltage, thereby accelerating the preparation rate of a thin coating on the surface of the substrate placed on the bracket 740.

Optionally, the bracket 740 may be a layered structure for placing the substrates in layers. Optionally, the bracket 740 may also be a ring bracket, a square bracket, a flat bracket, or a mesh bracket, and the like, not limited hereto.

Further, the coating apparatus 7100 further includes an air extraction means, wherein the air extraction means is communicated with an air extraction port of the coating chamber 710, for controlling the air pressure of the coating chamber 710 during the coating process. Optionally, the air extraction means is a dry pump, a molecular pump, or a Roots pump, or the like.

Further, this embodiment also provides a coating method for the coating apparatus 7100, including:
filling the coating chamber 710 with a gas monomer or monomer vapor, wherein the coating chamber 710 has the coating area 7101 for placing the substrate;
generating the plasma excitation field 730 within the coating chamber 710; and
entering the gas monomer or monomer vapor into the plasma excitation field 30 through the coating area 7101 to be activated, to prepare a thin coating on the surface of the substrate.

FIG. 12 shows a coating apparatus 7100A in a first variation embodiment of the present application different from the preferred embodiments of the present application in that, the coating apparatus 7100A includes a coating chamber 710, at least one monomer source 720, a plasma excitation field 730, and at least one bracket 740A, wherein the bracket 740A is provided in the coating chamber 710, wherein the bracket 740A has at least one support unit 741A for supporting a substrate, wherein the monomer source 720 is communicated with the coating chamber 710 for passing a gas monomer or monomer vapor into the coating chamber 710, wherein the plasma excitation field 730 is provided in the coating chamber 710 for activating the gas monomer or monomer vapor, wherein the support unit 741A of the bracket 740A may relatively reciprocate close to and away from the plasma excitation field 730, to prepare a thin coating on a surface of the substrate.

In this embodiment, the bracket 740A is movably provided in the coating chamber 710, wherein the support unit 741A of the bracket 740A is movably close to or away from the plasma excitation field 730. Optionally, there may be one or more support units 741A.

The feed port of the monomer source 720 is spaced apart from the plasma excitation field 730 at a certain distance, and does not overlap therewith, so as to provide an appropriate movement distance for the bracket 740A, and enable the support unit 741A to enter and exit the plasma excitation field 730.

In other words, in the coating chamber 710, the space area (the first space area) near the feed port of the monomer source 720 is filled with a large amount of a gas monomer or monomer vapor, and the space area (the second space area) near the electrode means 731 of the plasma excitation field 730 is filled with a large amount of the plasma source gas and discharges under the effect of a voltage to generate a large amount of plasma, so as to form a plasma environment. The first space area is adjacent to the second space area, wherein molecules in the first space area are mainly gas monomers or monomer vapors, and molecules in the second space area are mainly plasma, wherein the support unit 741A moves back and forth between the first space area and the second space area. It shall be understood that, the first space area and the second space area may have an overlapping area, but do not overlap completely.

The bracket 740A is a movable bracket for moving the substrate into and out of the plasma excitation field 730.

Specifically, the bracket 740A includes the support unit 741A and a movable unit 742A, wherein the support unit 741A is used to support the substrate, wherein the support unit 741A is connected to the movable unit 742A, and wherein the movable unit 742A may move within the coating chamber to approach and move away from the plasma excitation field 730. That is, in the above embodiments, the carrier frame is implemented as the support unit 741A, and the movable frame is implemented as the movable unit 742A.

Optionally, the movable unit 742A is a pulley or slideway structure. Optionally, the movable unit 742A is a retractable structure or the like.

Optionally, the plasma excitation field 730 is movably provided in the coating chamber 710, so that the bracket 740A is relatively close to and away from the plasma excitation field 730.

Further, the feed port of the monomer source 720 and the plasma excitation field 730 are located on two sides of the movement path of the bracket 740A. Further, the bracket 740A performs a reciprocating motion, wherein the support unit 741A of the bracket 740A moves back and forth between the plasma excitation field 730 and the feed port of the monomer source 720, to move the substrate repeatedly alternately approach the plasma excitation field 730 or the feed port of the monomer source 720. Optionally, the feed port of the monomer source 720 and the plasma excitation field 730 may be located on two sides of the coating chamber 710. Alternatively, the plasma excitation field 730 is located in the middle of the coating chamber 710, and the feed ports of the monomer source 720 are distributed on the surrounding sides of the coating chamber 710.

During the coating process, the feed port of the monomer source 720 continuously fills the coating chamber 710 with a gas monomer or monomer vapor, wherein the plasma excitation field 730 continuously releases a plasma source gas and provides a voltage for discharge to generate plasma, to form a plasma environment, wherein the support unit 741A of the bracket 740A reciprocates in and out of the plasma environment formed by the plasma excitation field 730. When the support unit 741A is close to the monomer source 720, the gas monomer or monomer vapor adheres to the surface of the substrate to form a thin layer, that is, the gas monomer or monomer vapor is adsorbed on the surface of the substrate. When the support unit 741A is close to the plasma excitation field 730, the gas monomer or monomer vapor adhered on the surface of the substrate is activated by the plasma. When the support unit 741A is close to the monomer source 720 again, the gas monomer or monomer vapor is grafted or polymerized with the activated molecules on the surface of the substrate, and the coating grows and thickens, and so on and so forth, until a thin coating or coating with a predetermined thickness is prepared on the surface of the substrate.

The difference between the present disclosure and the prior art is that, the prior art utilizes the plasma to effect on a gas monomer or monomer vapor in a space, wherein the gas monomer or monomer vapor molecules are completely exposed to the plasma, and decompose and generate various polymer products in the space, and then deposit on the surface of the substrate to prepare a thin coating or coating, resulting in low molecular integrity in and poor performance of the thin coating or coating; and in the present disclosure, the plasma generated by the plasma excitation field 730 effects only on the gas monomer or monomer vapor molecules adsorbed on the surface of the substrate, and then grafts or polymerizes with the gas monomer or monomer vapor molecules unaffected with the plasma to prepare a thin coating or coating, with high molecular integrity, so the performance of the thin coating or coating is better.

On the other hand, a portion of the monomer vapor diffuses into the plasma area, where it spatially decomposes and polymerizes and deposits on the surface of the substrate as it moves over, forming a part of a coating. This part of the polymer product has a higher degree of branching and crosslinking structure. The existence of a certain degree of branching and crosslinking in the coating is beneficial to improve the polymerization efficiency and the stability of the coating. The disclosure may conveniently control the branching and crosslinking proportion in the coating by adjusting the movement speed and residence time of the substrate between the monomer source and the plasma source, and obtain the best coating properties.

It is remarkable that, the movement path, movement speed, rhythm, residence time, cycle time, and movement time of the support unit 741A are all able to be preset to control the intermolecular branching and crosslinking proportion in the prepared coating, to ensure the performance, so as to be suitable for the preparation of the desired thin coating or coating, etc.

In this embodiment, the structural principles of the monomer source 720 and the plasma excitation field 730 are the same as those in this preferred embodiment, and are not described herein again.

Experiments show that, the uniformity and speed of the thin coating prepared by the coating apparatus of the present application are improved compared with the existing coating apparatus. For example, under the condition that the feed rate of the gas monomer or monomer vapor is 300 uL/3000 seconds, the thicknesses (in Table 1 below) of the upper, middle and lower layers of the three types (Example 1, Example 2, Example 3) of the thin coatings prepared by the coating apparatus of the present application and those (in Table 2 below) of the three types of the thin coatings prepared by the existing coating apparatus (Example 1, Example 2, Example 3) are compared in several groups as follows:

**Table 1 (thin coatings prepared by the coating apparatus of the present application)**

| Thin coating | Example 1 | Example 2 | Example 3 |
|---|---|---|---|
| Thickness of the upper layer (nm) | 343 | 365 | 368 |
| Thickness of the middle layer (nm) | 351 | 371 | 366 |
| Thickness of the lower layer (nm) | 346 | 374 | 359 |

**Table 2 (thin coatings prepared by the existing coating apparatus)**

| Thin coating | Example 1 | Example 2 | Example 3 |
|---|---|---|---|
| Thickness of the upper layer (nm) | 225 | 247 | 209 |
| Thickness of the middle layer (nm) | 203 | 187 | 231 |
| Thickness of the lower layer (nm) | 162 | 235 | 158 |

It can be seen that, the thicknesses and speeds of the thin coatings prepared by the coating apparatus of the present application are increased by 1.5-2 times compared with those of the existing coating apparatus, the thickness deviations between the upper layers, the middle layers and the lower layers of the thin coatings are relatively low, and the uniformity is high.

FIG. 13 shows a coating apparatus 7100B of a second variation embodiment of the present application. It differs from those in the above embodiments in that, the coating apparatus 7100B of this second variation embodiment includes a coating chamber 710, at least one monomer source 720, a plasma excitation field 730, and at least one bracket 740B, wherein the bracket 740B is provided in the coating chamber 710 and has at least one support unit 741B for supporting a substrate, wherein the monomer source 720 is communicated with the coating chamber 710 for feeding a gas monomer or monomer vapor into the coating chamber 710, wherein the plasma excitation field 730 is provided in the coating chamber 710 for activating the gas monomer or monomer vapor, wherein the support unit 741B of the bracket 740B may relatively reciprocate close to and away from the plasma excitation field 730 to prepare a thin coating on a surface of the substrate.

Further, the bracket 740B is rotatably provided in the coating chamber 710, and as the bracket 740B rotates, the support unit 741B reciprocates close to or away from the plasma excitation field 730. That is, the bracket 740B is a rotatable structure.

Specifically, the bracket 740B includes the support unit 741B and a rotatable unit 742B, wherein the support unit 741B is connected to the rotatable unit 742B, wherein the rotatable unit 742B is rotatably configured to the coating chamber 710, with the rotation of the rotatable unit 742B, the support unit 41B reciprocally approaches or moves away from the plasma excitation field 730.

Further, there are multiple support units 741B, and the various support units 741B are arranged in a ring on the rotatable unit 742B, wherein the rotatable unit 742B of the bracket 740B is located between the plasma excitation field 730 and the feed ports of the monomer source 720, with the rotation of the rotatable unit 742B of the bracket 740B, the various support units 741B are alternately reciprocating between the space area (the first space area) adjacent to the feed ports of the monomer source 720 and the space area (the second space area) near the plasma excitation field 730 in turn.

It shall be understood that, the rotation axis of the rotatable unit 742B is the middle position of the coating chamber 710, wherein the plasma excitation field 730 is located on one side of the coating chamber 710, and wherein the monomer source 720 is located on another side of the coating chamber 710 and does not coincide with the plasma excitation field 730.

During the coating process, when the support unit 741B is close to the feed port of the monomer source 720, that is, enters the first space area, the gas monomer or monomer vapor adheres to the surface of the substrate to form a thin coating, i.e. the gas monomer or monomer vapor is adsorbed on the surface of the substrate. When the support unit 741B is close to the plasma excitation field 730, that is, enters the second space area, the gas monomer or monomer vapor attached to the surface of the substrate is activated by the plasma. When the support unit 741B approaches the monomer source 720 again, that is, enters the first space area, the gas monomer or monomer vapor is grafted or polymerized with the activated molecules on the surface of the substrate, and the coating grows and thickens, and this is repeated continuously, until a thin coating or coating with a predetermined thickness is prepared on the surface of the substrate.

That is to say, the bracket 740B performs a circular motion or elliptical motion, wherein each of the substrates is located at the circumferential position of the bracket 740B, so as to reciprocate circular motion or elliptical motion along with the bracket 740B, and alternately enter and exit the plasma excitation field 730 in a circular motion or elliptical motion.

It is remarkable that, the rotation speed, rhythm, cycle time of the rotatable unit 742B, the rotation radius of the support unit 741B, and the residence time in each of the first space area and the second space area are all able to be predetermined, to control and adjust the proportion of intermolecular branching and crosslinking in the prepared coating to ensure the performance, so as to be suitable for preparing a desired thin coating or coating with good performance.

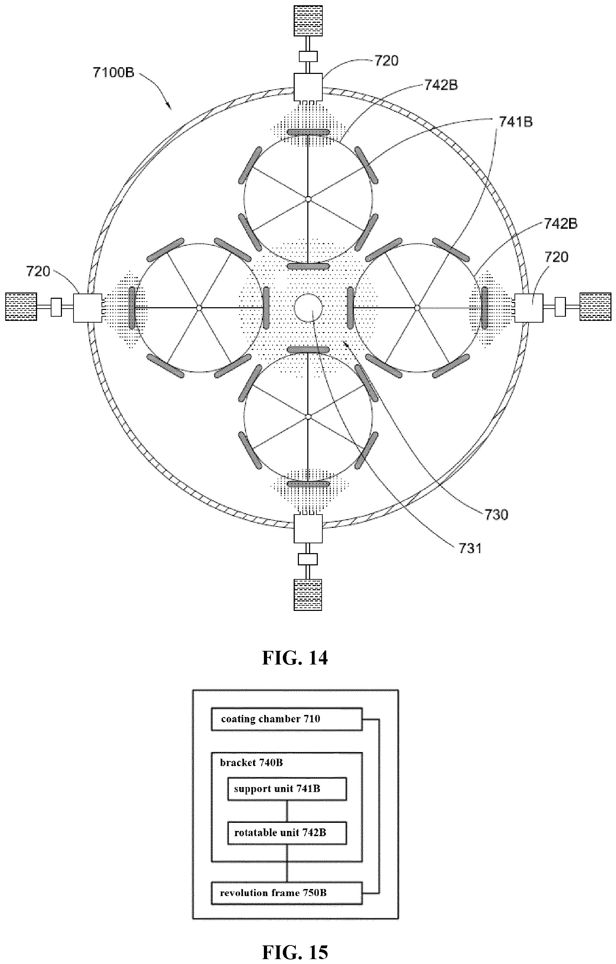

FIGS. 14 and 15 show a variant implementation of the second variation embodiment of the present application, wherein the plasma excitation field 730 is located in the middle position of the coating chamber 710, wherein a plurality of the monomer sources 720 are respectively located on the surrounding sides of the coating chamber 710, wherein a plurality of the brackets 740B are respectively located between the monomer source 720 and the plasma excitation field 730 correspondingly, and wherein the various brackets 740B do not interfere with each other. That is to say, the middle area of the coating chamber 710 is the second space area, and is full of a large amount of plasma, wherein the surrounding area of the coating chamber 710 is the first space area, and is full of a large amount of gas monomer or monomer vapor molecules, wherein the various brackets 740B is arranged in a ring in the coating chamber 710, and the support units 741B of each of the brackets 740B alternately move between the first space area and the second space to realize coating in bulk.

Further, the electrode means 731 of the plasma excitation field 730 is provided at a middle position of the coating chamber 710, wherein the electrode means 731 is a columnar structure, wherein the electrode means 731 is located in the middle of the various brackets 740B, wherein the support units 741B of each of the brackets 740B rotate about the axis of the electrode means 731. The first electrode 7311 of the electrode means 731 is juxtaposed with the second electrode 7312, wherein the first electrode 7311 is a radio frequency electrode, and wherein the second electrode 7312 is grounded. Further, the first electrode 7311 may be a plurality of columnar structures with right-angled cross sections arranged in a ring, or a structure of other shapes, not limited hereto. The gas suction port of the coating chamber 710 is located above or below the electrode means 731 for exhausting the gas in the coating chamber 710 during the coating process.

Optionally, the electrode means 731 of the plasma excitation field 730 is provided at a middle position of the coating chamber 710, wherein an air extraction column is provided at a middle position of the coating chamber 710, wherein the side wall of the air extraction column is provided with an exhaust hole to communicate with the outside world, and the air extraction column is connected to an air extraction means to exhaust the gas in the coating chamber 710 and control the air pressure. The second electrode 7311 of the electrode means 731 is electrically connected to the air extraction column and grounded, wherein the first electrode 7312 is provided outside the air extraction column to serve as a radio frequency electrode.

Optionally, the air extraction column serves as the second electrode 7312 of the electrode means 731 and is grounded, wherein the first electrode 7311 is provided outside the air extraction column, and wherein the first electrode 7311 may be a cylindrical columnar structure so as to be sleeved on the outside of the air extraction column. A side wall of the first electrode 7311 has a plurality of through-holes to ensure the discharge rate of the gas in the coating chamber 710 from the air extraction column.

Optionally, the first electrode 7311 of the electrode means 731 may be provided on the bracket 740B, and the second electrode 7312 is electrically connected to the air extraction column and grounded, so that the air extraction column acts as the second electrode. For example, the bracket 740B includes an electrode element made of a conductive material, wherein the electrode element is electrically connected to the first electrode 7311, or the bracket 740B is made of a conductive material and is electrically connected to the first electrode 7311.

Further, the coating chamber 710 is a cylindrical structure.

As shown in FIG. 15, further, the coating apparatus 7100B further includes a revolution frame 750B, wherein the revolution frame 750B is rotatably provided in the coating chamber 710 and takes the center of the coating chamber 710 as an axis, and wherein the rotatable units 742B of each of the brackets 70B are configured on the revolution frame 750B in a ring, and rotate with the rotation of the revolution frame 750B, that is, the brackets 740B takes the center of the coating chamber 710 as an axis to revolve.

Optionally, the rotation axis of the rotatable unit 742B is located at a position of a half radius of the coating chamber 710, wherein each of the brackets 740B rotates around its own axis. And, during the rotation process, the substrate supported by each of the support units 741B moves alternately between the first space area and the second space area, respectively, to realize coating.

That is to say, the bracket 740B and the revolution frame 750B drive each of the substrates to perform planetary motion or planetary-like motion, wherein the plasma excitation field 730 is provided on the path where the substrate passes through, so that each of the substrates alternately enters and exits the plasma excitation field 730.

It is remarkable that, the revolution speed of the revolution frame 750B may be preset, wherein the revolution radius of the bracket 740B may be preset. Further, the revolution and rotation speed ratio and the revolution and rotation revolution ration between the revolution frame 750B and the bracket 740B are all able to be preset, so as to adjust the residence time or movement speed or the like of the substrate in the first space area or the second space area, to control the coating.

Optionally, the bracket or structure for supporting and moving the substrate is implemented as a structure capable of spherical motion, so as to support and drive each of the substrates to perform spherical motion in the coating chamber 710, wherein the plasma excitation field 730 is provided in a local area of the spherical surface to be located on a path that the substrate passes through, so that the substrate alternately enters and exits the plasma excitation field 730.

Optionally, the bracket or structure for supporting and moving the substrate is implemented as a structure capable of swing back and forth, so as to support and drive each of the substrates to swing back and forth in the coating chamber 710, wherein the plasma excitation field 730 is provided on the swing path, so that the substrate enters and exits the plasma excitation field 730 back and forth by swing.

It will be understood by those skilled in the art that, the bracket or structure for supporting the substrate may be fixed to the coating chamber, wherein the plasma excitation field is implemented to be movable, wherein the electrode means of the plasma excitation field moves in the coating chamber 710 through a movable structure, so that the substrate enters and exits the plasma excitation field relatively. Said movable structure may be a reciprocating motion structure, swing back and forth structure, circular motion structure, spherical motion structure, planetary motion structure, etc., and is not limited hereto.

Further, the present application also provides a coating method for the coating apparatus, including:
filling the coating chamber with a gas monomer or monomer vapor;
forming the plasma excitation field within the coating chamber; and
moving or rotating the bracket relatively close to or away from the plasma excitation field, wherein the bracket is used for supporting a substrate to prepare a thin coating on a surface of the substrate.

Those skilled in the art will appreciate that, the embodiments of the present disclosure shown in the foregoing description and the accompanying drawings are by way of example only and are not intended to limit the present disclosure. The advantages of the present disclosure have been completely and effectively realized. The functionality and structural principles of the present disclosure have been shown and illustrated in the embodiments, and embodiments of the disclosure may be varied or modified without departing from the principles described herein.

## Claims

1. A coating apparatus for forming a coating on a surface of a substrate, comprising:
a chamber body having a reaction chamber provided with a substrate positioning area for placing the substrate;
a monomer release source having a release inlet for introducing a coating forming material into the reaction chamber of the chamber body; and
a plasma excitation source positioned in the reaction chamber of the chamber body for exciting the coating forming material, wherein the substrate positioning area is configured at a position between the monomer release source and the plasma excitation source in a manner that the substrate is adapted for being arranged between the monomer release source and the plasma excitation source.

2. The coating apparatus according to claim 1, further comprising a support frame for supporting the substrate, wherein the support frame is disposed in the substrate positioning area of the chamber body.

3. The coating apparatus according to claim 1, further comprising a support frame for supporting the substrate, wherein the support frame is configured in the substrate positioning area of the chamber body.

4. The coating apparatus according to claim 1, further comprising a support frame for supporting the substrate in the substrate positioning area of the chamber body, wherein the support frame is operable to move between the monomer release source and the plasma excitation source within the reaction chamber of the chamber body.

5. The coating apparatus according to claim 1, wherein an electrical discharge type of the plasma excitation source is selected from one or more of the following combinations: a direct current, an alternating current discharge, an audio frequency discharge, a radio frequency discharge, a microwave discharge, a medium frequency discharge, a penning discharge, a spark discharge and a pulse discharge.

6. The coating apparatus according to claim 1, further comprising a monomer supply unit which comprises a material storage device for storing a raw material of the coating forming material, and a vaporizer for vaporizing the raw material to form a monomer vapor of the coating forming material.

7. The coating apparatus according to claim 1, further comprising a monomer supply unit, wherein the monomer supply unit comprises a material storage device communicated with the monomer release source for storing a gaseous monomer of the coating forming material.

8. A coating apparatus for forming a coating on a surface of a substrate, comprising:
a chamber body having a reaction chamber;
a support frame having a support area for supporting the substrate within the reaction chamber of the chamber body;
a monomer release source having a release inlet for introducing a coating forming material into the reaction chamber of the chamber body; and
a plasma excitation source positioned in the reaction chamber of the chamber body for exciting the coating forming material, wherein the support area of the support frame is positioned at a position between the monomer release source and the plasma excitation source in a manner that the substrate is configured between the monomer release source and the plasma excitation source.

9. The coating apparatus according to claim 8, wherein the support frame is configured in the reaction chamber of the chamber body between the monomer release source and the plasma excitation source.

10. The coating apparatus according to claim 8, wherein the support frame is operable to move in the reaction chamber of the chamber body between the monomer release source and the plasma excitation source.

11. The coating apparatus according to claim 10, wherein a movement of the support frame is selected from one or more of the following combinations: a linear movement, a curvilinear movement, a sliding movement and a rotational movement.

12. The coating apparatus according to claim 8, wherein the plasma excitation source is configured on the chamber body remotely and is spaced away from the monomer release source.

13. The coating apparatus according to claim 8, wherein the plasma excitation source is configured on the support frame at a side of the support frame which is opposite to the monomer release source.

14. The coating apparatus according to claim 8, wherein the chamber body has two side walls which are opposite to each other, and the monomer release source and the plasma excitation source are respectively disposed in the reaction chamber of the chamber body at positions adjacent to the two sides walls which are opposite to each other.

15. The coating apparatus according to claim 8, wherein the chamber body has a side wall, and the monomer release source and the plasma excitation source are disposed in the reaction chamber of the chamber body at positions adjacent to the side wall of the chamber body and are remotely and are spaced away from each other.

16. The coating apparatus according to claim 8, wherein the chamber body has two adjacent side walls, and the monomer generation source and the plasma excitation source are respectively disposed in the reaction chamber of the chamber body at positions adjacent to the two adjacent side walls of the chamber body.

17. The coating apparatus according to claim 8, wherein an electrical discharge type of the plasma excitation source is selected from one or more of the following combinations: a direct current, an alternating current discharge, an audio frequency discharge, a radio frequency discharge, a microwave discharge, a medium frequency discharge, a penning discharge, a spark discharge and a pulse discharge.

18. The coating apparatus according to claim 8, wherein the plasma excitation source comprises an electrode means for applying electric power to the coating forming material, and the electrode means comprises a pair of electrodes for performing a radio frequency discharge.

19. The coating apparatus according to claim 8, wherein the plasma excitation source comprises an electrode means for applying electric power to the coating forming material, and the electrode means comprises a planar electrode extending in the reaction chamber.

20. The coating apparatus according to claim 8, wherein a cross section of the reaction chamber of the chamber body is selected from the group consisting of a circular shape, an oval shape, and a polygonal shape.

21. The coating apparatus according to claim 8, wherein the support frame comprises a plurality of support areas arranged around the plasma excitation source to support a plurality of substrates.

22. The coating apparatus according to claim 21, wherein the support frame is operable to rotate about the plasma excitation source.

23. The coating apparatus according to claim 21, wherein the support frame comprises a carrier frame having the plurality of support areas, wherein the carrier frame is operable to rotate about a central axis thereof around the plasma excitation source.

24. The coating apparatus according to claim 21, wherein the support frame comprises a movable frame which is operable to rotate about a central axis of the chamber body and a carrier frame having the plurality of support areas, and the carrier frame is configured on the movable frame and can be operable to rotate about a central axis of the movable frame around the plasma excitation source.

25. The coating apparatus according to claim 21, wherein the plasma excitation source comprises an electrode means for applying electric power to the coating forming material, and the electrode means comprises a plurality of first electrodes and a plurality of second electrodes which are alternatingly arranged along a circumferential direction as positive and negative electrodes.

26. The coating apparatus according to claim 25, wherein each of the first electrodes and the second electrodes is an electrode plate.

27. The coating apparatus according to claim 21, wherein the plasma excitation source comprises an electrode means for applying electric power to the coating forming material, the electrode means comprises a plurality of first electrodes and a plurality of second electrodes which serve as positive and negative electrodes, and each of the first electrodes and the second electrodes is a cylindrical electrode and the first electrode is sleeved around the second electrode.

28. The coating apparatus according to claim 27, wherein the second electrode further serves as a pumping pipe communicated with an outer side of the reaction chamber of the chamber body.

29. The coating apparatus according to claim 8, further comprising a monomer supply unit which comprises a material storage device for storing a raw material of the coating forming material, and a vaporizer for vaporizing the raw material to form a monomer vapor of the coating forming material.

30. The coating apparatus according to claim 8, further comprising a monomer supply unit, wherein the monomer supply unit comprises a material storage device communicated with the monomer release source for storing a gaseous monomer of the coating forming material.

31. A coating method for forming a coating on a surface of a substrate, comprising:
(a) arranging the substrate in a reaction chamber of a chamber body at a position between a monomer release source and a plasma excitation source; and
(b) introducing a coating forming material into the reaction chamber through the monomer release source for forming a polymer coating on a surface of the substrate in the effect of the plasma excitation source.

32. The coating method according to claim 31, further comprising: repeatedly moving the substrate between the monomer release source and the plasma excitation source.

33. The coating method according to claim 31, further comprising: rotating the substrate around the plasma excitation source.

34. The coating method according to claim 31, further comprising: using a support frame to support the substrate positioned between the monomer release source and the plasma excitation source.

35. The coating method according to claim 34, further comprising: arranging the support frame in a substrate positioning area of the chamber body, wherein the substrate positioning area is configured between the monomer release source and the plasma excitation source.

36. The coating method according to claim 34, further comprising: configuring the support frame movably on the chamber body.

37. The coating method according to claim 36, wherein a movement of the support frame is selected from one or more of the following combinations: a linear movement, a curvilinear movement, a sliding movement and a rotational movement.

38. The coating method according to claim 31, wherein the plasma excitation source is configured on the chamber body remotely and is spaced away from the monomer release source.

39. The coating method according to claim 31, wherein the plasma excitation source is configured on the support frame at a side of the support frame which is opposite to the monomer release source.

40. The coating method according to claim 31, wherein the chamber body has two side walls which are opposite to each other, and the monomer release source and the plasma excitation source are respectively disposed in the reaction chamber of the chamber body at positions adjacent to the two sides walls which are opposite to each other.

41. The coating method according to claim 31, wherein the chamber body has a side wall, and the monomer release source and the plasma excitation source are disposed in the reaction chamber of the chamber body at positions adjacent to the side wall of the chamber body and are remotely and are spaced away from each other.

42. The coating method according to claim 31, wherein the chamber body has two adjacent side walls, and the monomer generation source and the plasma excitation source are respectively disposed in the reaction chamber of the chamber body at positions adjacent to the two adjacent side walls of the chamber body.

43. The coating method according to any one of claim 31 to claim 42, further comprising: introducing the coating forming material into the reaction chamber from one side of the reaction chamber towards the other opposite side through the monomer release source.

44. The coating method according to any one of claim 31 to claim 42, further comprising: introducing the coating forming material into the reaction chamber from the periphery of the reaction chamber through a plurality of monomer release sources.

45. The coating method according to any one of claim 31 to claim 42, further comprising: introducing the coating forming material into the reaction chamber from the top side of the reaction chamber through the monomer release source.

46. The coating method according to any one of claim 31 to claim 42, wherein an electrical discharge type of the plasma excitation source is selected from one or more of the following combinations: a direct current, an alternating current discharge, an audio frequency discharge, a radio frequency discharge, a microwave discharge, a medium frequency discharge, a penning discharge, a spark discharge and a pulse discharge.

47. The coating method according to any one of claim 31 to claim 42, wherein the plasma excitation source comprises an electrode means for applying electric power to the coating forming material, and the electrode means comprises a pair of electrodes for performing a radio frequency discharge.

48. The coating method according to any one of claim 31 to claim 42, wherein the plasma excitation source comprises an electrode means for applying electric power to the coating forming material, and the electrode means comprises a planar electrode extending in the reaction chamber.

49. The coating method according to any one of claim 31 to claim 42, wherein a cross section of the reaction chamber of the chamber body is selected from the group consisting of a circular shape, an oval shape, and a polygonal shape.

50. The coating method according to any one of claim 31 to claim 42, further comprising: vaporizing a raw material to form the coating forming material as a monomer vapor, and transmitting the coating forming material to the monomer release source, so as to supply the coating forming material into the reaction chamber of the chamber body.

51. The coating method according to any one of claim 31 to claim 42, further comprising: transmitting a gaseous coating forming material to the monomer release source, so as to supply the coating forming material into the reaction chamber of the chamber body.

52. A coating method for forming coatings on surfaces of a plurality of substrates, comprising:
(α) surrounding a plasma excitation source by the plurality of the substrates, and configuring a monomer release source and the plasma excitation source on two opposite sides of the plurality of substrates; and
(β) releasing a coating forming material into a reaction chamber of a chamber body to perform a plasma processing on the plurality of substrates by the plasma excitation source.

53. The coating method according to claim 52, further comprising: circumferentially arranging a plurality of monomer release sources to release the coating forming material toward the plasma excitation source at a radial direction of the reaction chamber.

54. The coating method according to claim 52, further comprising: moving the plurality of substrates around the plasma excitation source.

55. The coating method according to claim 52, wherein a cross section of the reaction chamber may be a circular shape or an oval shape, the plurality of the monomer release sources are arranged in a circumferential direction of the reaction chamber to radially introduce the coating forming material into the reaction chamber.

56. The coating method according to claim 52, further comprising: supporting the plurality of substrates on a support frame.

57. The coating method according to claim 56, further comprising: configuring the support frame on the chamber body.

58. The coating method according to claim 57, further comprising: configuring the support frame movably on the chamber body, so that when the support frame moves, the plurality of substrates can move together with the support frame.

59. The coating method according to claim 52, further comprising: rotating the plurality of substrates around the plasma excitation source.

60. The coating method according to claim 58, further comprising: rotating the support frame about its central axis and about the plasma excitation source.

61. The coating method according to claim 52, further comprising: rotating a movable frame about a central axis of the chamber body, and the plurality of substrates are supported by a carrier frame configured on the movable frame.

62. The coating method according to claim 61, further comprising: moving the carrier frame, and the carrier frame and the movable frame are moved relative to each other.

63. The coating method according to claim 62, wherein a movement of the support frame is selected from one or more of the following combinations: a linear movement, a curvilinear movement, a sliding movement and a rotational movement.

64. The coating method according to claim 62, wherein the carrier frame is configured on the movable frame and is operable to rotate about its central axis.

65. The coating method according to claim 64, rotating a plurality of carrier frames about their central axes around the plasma excitation source.

66. The coating method according to any one of claim 52 to claim 65, wherein the plasma excitation source comprises an electrode means for applying electric power to the coating forming material, and the electrode means comprises a plurality of first electrodes and a plurality of second electrodes which are alternatingly arranged along a circumferential direction as positive and negative electrodes.

67. The coating method according to claim 66, wherein each of the first electrodes and the second electrodes is an electrode plate.

68. The coating method according to any one of claim 52 to claim 65, wherein the plasma excitation source comprises an electrode means for applying electric power to the coating forming material, the electrode means comprises a plurality of first electrodes and a plurality of second electrodes which serve as positive and negative electrodes, and each of the first electrodes and the second electrodes is a cylindrical electrode and the first electrode is sleeved around the second electrode.

69. The coating method according to claim 68, wherein the second electrode further serves as a pumping pipe communicated with an outer side of the reaction chamber of the chamber body.

70. The coating method according to any one of claim 52 to claim 65, wherein an electrical discharge type of the plasma excitation source is selected from one or more of the following combinations: a direct current, an alternating current discharge, an audio frequency discharge, a radio frequency discharge, a microwave discharge, a medium frequency discharge, a penning discharge, a spark discharge and a pulse discharge.

71. The coating method according to any one of claim 52 to claim 65, further comprising: vaporizing a raw material to form the coating forming material as a monomer vapor, and transmitting the coating forming material to the monomer release source, so as to supply the coating forming material into the reaction chamber of the chamber body.

72. The coating method according to any one of claim 52 to claim 65, further comprising: transmitting a gaseous coating forming material to the monomer release source, so as to supply the coating forming material into the reaction chamber of the chamber body.

73. A coating apparatus for forming a coating on a surface of a substrate, comprising:
a chamber body having a reaction chamber;
a support frame having a support area for supporting the substrate within the reaction chamber of the chamber body;
a monomer release source having a release inlet for introducing a coating forming material into the reaction chamber of the chamber body; and
a plasma excitation source positioned in the reaction chamber of the chamber body for exciting the coating forming material, wherein the support frame is movably configured in the reaction chamber, the substrate can move with the support frame to form a movement path of the substrate, and on at least a part of the movement path, the substrate is located at a position between the monomer release source and the plasma excitation source.

74. The coating apparatus according to claim 73, wherein the movement path of the substrate may comprise a first part and a second part, in the first part, the monomer release source and the plasma excitation source are located on two sides of the substrate respectively, and in the second part, the monomer release source and the substrate are located on two sides of the plasma excitation source respectively.

75. The coating apparatus according to claim 73, wherein the movement path of the substrate may comprise a first part and a second part, in the first part, the monomer release source and the plasma excitation source are located on two sides of the substrate respectively, and in the second part, the plasma excitation source and the substrate are located on two sides of the monomer release source respectively.

76. The coating apparatus according to claim 74, wherein the first part of the movement path is larger than the second part of the movement path.

77. The coating apparatus according to claim 75, wherein the first part of the movement path is larger than the second part of the movement path.

78. The coating apparatus according to claim 75, wherein the support frame is movably configured on the chamber body.

79. The coating apparatus according to claim 78, wherein a movement of the support frame is selected from one or more of the following combinations: a linear movement, a curvilinear movement, a sliding movement and a rotational movement.

80. The coating apparatus according to claim 73, wherein the plasma excitation source is configured on the chamber body remotely and is spaced away from the monomer release source.

81. The coating apparatus according to claim 73, wherein the chamber body has a side wall, and the monomer release source and the plasma excitation source are disposed in the reaction chamber of the chamber body at positions adjacent to the side wall of the chamber body and are remotely and are spaced away from each other.

82. The coating apparatus according to claim 73, wherein the chamber body has two adjacent side walls, and the monomer generation source and the plasma excitation source are respectively disposed in the reaction chamber of the chamber body at positions adjacent to the two adjacent side walls of the chamber body.

83. The coating apparatus according to any one of claim 73 to claim 82, wherein an electrical discharge type of the plasma excitation source is selected from one or more of the following combinations: a direct current, an alternating current discharge, an audio frequency discharge, a radio frequency discharge, a microwave discharge, a medium frequency discharge, a penning discharge, a spark discharge and a pulse discharge.

84. The coating apparatus according to any one of claim 73 to claim 82, wherein the plasma excitation source comprises an electrode means for applying electric power to the coating forming material, and the electrode means comprises a pair of electrodes for performing a radio frequency discharge.

85. The coating apparatus according to any one of claim 73 to claim 82, wherein the plasma excitation source comprises an electrode means for applying electric power to the coating forming material, and the electrode means comprises a planar electrode extending in the reaction chamber.

86. The coating apparatus according to any one of claim 73 to claim 82, wherein a cross section of the reaction chamber of the chamber body is selected from the group consisting of a circular shape, an oval shape, and a polygonal shape.

87. A coating method for forming a coating on a surface of a substrate, comprising:
(I) moving the substrate in a reaction chamber of a chamber body to define a movement path of the substrate, wherein on at least a part of the movement path, the substrate is located at a position between a monomer release source and a plasma excitation source; and
(II) releasing the coating forming material into the reaction chamber of the chamber body to perform a plasma processing on the substrate by the plasma excitation source.

88. The coating method according to claim 87, wherein the movement path of the substrate may comprise a first part and a second part, in the first part, the monomer release source and the plasma excitation source are located on two sides of the substrate respectively, and in the second part, the monomer release source and the substrate are located on two sides of the plasma excitation source respectively.

89. The coating method according to claim 87, wherein the movement path of the substrate may comprise a first part and a second part, in the first part, the monomer release source and the plasma excitation source are located on two sides of the substrate respectively, and in the second part, the plasma excitation source and the substrate are located on two sides of the monomer release source respectively.

90. The coating method according to claim 88 or claim 89, wherein the first part of the movement path is larger than the second part of the movement path.

91. A coating apparatus, comprising:
a coating chamber;
at least one bracket configured in the coating chamber, wherein the bracket is provided with a support unit to support a substrate;
at least one monomer source communicated with the coating chamber and used for introducing a gas monomer or a monomer vapor into the coating chamber;
a plasma excitation field provided in the coating chamber and used for activating the gas monomer or the monomer vapor, wherein the support unit of the bracket may relatively reciprocate close to and away from the plasma excitation field, so as to prepare a coating on a surface of the substrate.

92. The coating apparatus according to claim 91, wherein the plasma excitation field comprises an electrode means, the coating apparatus further comprises a plasma source communicated with the coating chamber and used for introducing a plasma source gas into the coating chamber, and the electrode means can be used to provide a voltage to discharge the gas to generate a plasma environment.

93. The coating apparatus according to claim 91 or claim 92, wherein the bracket is configured to support and move the substrate back and forth between the plasma excitation field and the monomer source.

94. The coating apparatus according to claim 91 or claim 92, wherein the bracket is configured to support and swing the substrate back and forth between the plasma excitation field and the monomer source.

95. The coating apparatus according to claim 91 or claim 92, wherein the bracket is configured to support and drive the substrate to perform an elliptical circular motion between the plasma excitation field and the monomer source.

96. The coating apparatus according to claim 91 or claim 92, wherein the bracket is configured to support and drive the substrate to perform a spherical motion between the plasma excitation field and the monomer source.

97. The coating apparatus according to claim 91 or claim 92, wherein the bracket is configured to support and drive the substrate to perform a planetary motion between the plasma excitation field and the monomer source.

98. The coating apparatus according to claim 91 or claim 92, wherein an electrical discharge type of the plasma excitation field is selected from one or more of the following combinations: a direct current, an alternating current discharge, an audio frequency discharge, a radio frequency discharge, a microwave discharge, a medium frequency discharge, a penning discharge, a spark discharge and a pulse discharge.

99. A coating apparatus, comprising:
a coating chamber having a coating area for placing a substrate;
at least one monomer source communicated with the coating chamber and used for introducing a gas monomer or a monomer vapor into the coating chamber; and
a plasma excitation field provided in the coating chamber and used for activating the gas monomer or the monomer vapor, wherein the plasma excitation field and the monomer source are respectively located on two sides of the coating area to prepare a coating on a surface of the substrate.

100. A coating method, comprising:
introducing a gas monomer or a monomer vapor into a coating chamber;
generating a plasma excitation field in the coating chamber; and
moving or rotating at least one bracket relatively close to or away from the plasma excitation field, wherein the at least one bracket is used for supporting a substrate to prepare a coating on a surface of the substrate.

101. A coating method, comprising:
introducing a gas monomer or a monomer vapor into a coating chamber which has a coating area for placing a substrate;
generating a plasma excitation field in the coating chamber; and
activating the gas monomer or the monomer vapor which enters the plasma excitation field through the coating area, so as to prepare a coating on a surface of the substrate.
